# EUROPEAN PATENT APPLICATION

(11) **EP 4 836 633 A2**
(43) Date of publication of application: **04.11.2026**
(21) Application number: 26164417.3
(22) Date of filing: 12.03.2026
(51) Int. Cl.: H10D 84/83, H10D 84/01, H10D 84/85, H10D 30/01, H10D 84/03

(54) **SEMICONDUCTOR DEVICE INCLUDING MULTI-GATE TRANSISTORS AND METHOD FOR FABRICATING THE SAME**

(30) Priority: 30.04.2025 KR 20250057258
(71) Applicant: Samsung Electronics Co., Ltd., Suwon-si, Gyeonggi-do 16677 (KR)
(72) Inventor: CHOI, Woo Hyeon, 16677 Suwon-si (KR); SONG, Hye Won, 16677 Suwon-si (KR); KANG, Myung Il, 16677 Suwon-si (KR); CHOI, Do Young, 16677 Gyeonggi-do (KR)
(74) Representative: Marks & Clerk LLP

(57) **Abstract**

A semiconductor device including a forksheet field effect transistor (FET) includes a substrate, a wall structure on the substrate, the wall structure including a first side surface and an opposite second side surface, a first active pattern and a second active pattern on the first side surface and the second side surface, respectively, a gate structure on the first active pattern and the second active pattern, a first epitaxial pattern which is connected to the first active pattern on a side surface of the gate structure, and a second epitaxial pattern which is connected to the second active pattern on the side surface of the gate structure, where the wall structure includes a wall pattern including a first insulating material, and a liner film including a second insulating material and interposed between the first epitaxial pattern and the wall pattern and between the second epitaxial pattern and the wall pattern.

## Description

### BACKGROUND

In order to improve a degree of integration of integrated circuit devices, multi-gate transistors can be utilized in which a silicon body having a fin or nanowire shape is formed on a substrate and a gate is formed on a surface of the silicon body. Since such a multi-gate transistor utilizes a three-dimensional channel, which facilitates scaling of integration in the devices. Further, even if a gate length of the multi-gate transistor is not increased, the current control capability may be improved. Furthermore, a SCE (short channel effect) in which potential of a channel region is influenced by a drain voltage may be effectively suppressed.

### SUMMARY

The present disclosure relates to a semiconductor device and a method for fabricating the same, and more particularly, to a semiconductor device including a forksheet field effect transistor (FET) and a method for fabricating the same.

To improve the degree of integration of integrated circuit devices, some approaches implement a forksheet field effect transistor (forksheet FET) in which adjacent multi-gate transistors are separated using an insulating wall structure.

Aspects of the present disclosure provide a semiconductor device having improved performance and process margin.

Aspects of the present disclosure also provide a method for fabricating a semiconductor device having improved performance and process margin.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an aspect of the present disclosure, there is provided a semiconductor device comprising a substrate, a wall structure which extends in a first direction on the substrate, the wall structure including a first side surface and a second side surface opposite to each other in a second direction intersecting the first direction, a first active pattern which extends in the first direction, on the first side surface, a second active pattern which extends in the first direction, on the second side surface, a gate structure which extends in the second direction, on the first active pattern and the second active pattern, a first epitaxial pattern which is connected to the first active pattern in the first direction, on a side surface of the gate structure, and a second epitaxial pattern which is connected to the second active pattern in the first direction, on the side surface of the gate structure, wherein the wall structure includes a wall pattern that extends in the first direction and includes a first insulating material, and a liner film that extends along a lower surface and a side surface of the wall pattern and includes a second insulating material different from the first insulating material, and the liner film is interposed between the first epitaxial pattern and the wall pattern and between the second epitaxial pattern and the wall pattern.

According to an aspect of the present disclosure, there is provided a semiconductor device comprising a substrate which includes a first region and a second region, a first bridge pattern which is spaced apart from the substrate and extends in a first direction, on the first region, a second bridge pattern which is spaced apart from the substrate and extends in the first direction, on the second region, a gate electrode which extends in a second direction intersecting the first direction, the first bridge pattern and the second bridge pattern penetrating through the gate electrode, a gate spacer which extends along a side surface of the gate electrode, the first bridge pattern and the second bridge pattern penetrating through the gate spacer, a first epitaxial pattern which is connected to the first bridge pattern in the first direction, on a side surface of the gate spacer, a second epitaxial pattern which is connected to the second bridge pattern in the first direction, on the side surface of the gate spacer, and a wall structure which separates the first bridge pattern and the second bridge pattern, and separates the first epitaxial pattern and the second epitaxial pattern, between the first region and the second region, wherein the wall structure includes a wall pattern that extends in the first direction and includes a first insulating material, and a liner film that extends along a lower surface and a side surface of the wall pattern and includes a second insulating material different from the first insulating material, and a thickness of the liner film interposed between the first epitaxial pattern and the wall pattern is equal to or greater than a thickness of the gate spacer.

According to an aspect of the present disclosure, there is provided a semiconductor device comprising a substrate which includes a first side and a second side that are opposite each other, a wall structure which extends in a first direction on the first side, the wall structure including a first side surface and a second side surface that are opposite each other in a second direction intersecting the first direction, a first bridge pattern which is spaced apart from the substrate on the first side surface and extends in the first direction, an upper surface of the first bridge pattern including a (110) crystal plane, a second bridge pattern which is spaced apart from the substrate on the second side surface and extends in the first direction, an upper surface of the second bridge pattern including a (110) crystal plane, a gate electrode which extends in the second direction, the first bridge pattern and the second bridge pattern penetrating the gate electrode, a gate spacer which extends along a side surface of the gate electrode, the first bridge pattern and the second bridge pattern penetrating the gate spacer, a first epitaxial pattern which is connected to the first bridge pattern in the first direction, on a side surface of the gate spacer, a second epitaxial pattern which is connected to the second bridge pattern in the first direction, on the side surface of the gate spacer, a back wiring structure on the second side, and a back source/drain contact which penetrates the substrate, the back source/drain contact connecting the first epitaxial pattern and the back wiring structure, wherein the wall structure includes a wall pattern that extends in the first direction and includes a first insulating material, and a liner film that extends along a lower surface and a side surface of the wall pattern and includes a second insulating material different from the first insulating material, a height of an uppermost portion of the liner film interposed between the first epitaxial pattern and the wall pattern is lower than a height of an uppermost portion of the first bridge pattern, a thickness of the liner film interposed between the first epitaxial pattern and the wall pattern is equal to or greater than a thickness of the gate spacer, and a part of the gate electrode is interposed between the first bridge pattern and the second bridge pattern in the second direction.

At least some of the above and other features of the invention are set out in the claims.

### BRIEF DESCRIPTION OF THE DRAWINGS

The above and other aspects and features of the present disclosure will become more apparent by describing in detail example implementations thereof with reference to the attached drawings, in which:
FIG. 1 is a layout diagram for explaining the semiconductor device according to several implementations.
FIG. 2 is a cross-sectional view taken along line A-A of FIG. 1.
FIGS. 3A and 3B are various enlarged views for explaining a region R1 of FIG. 2.
FIG. 4 is a cross-sectional view taken along line B-B of FIG. 1.
FIGS. 5A and 5B are various enlarged views for explaining a region R2 of FIG. 4.
FIG. 6 is a cross-sectional view taken along line C-C of FIG. 1.
FIG. 7 is a cross-sectional view for explaining a semiconductor device according to some implementations.
FIG. 8 is a cross-sectional view for explaining a semiconductor device according to some implementations.
FIGS. 9 and 10 are cross-sectional views for explaining a semiconductor device according to some implementations.
FIGS. 11, 12, 13, 14, 15, 16, 17, 18, 19, 20, 21, 22, 23, 24, 25, 26, 27, 28, 29, 30, 31, 32, 33, 34, 35, 36, and 37 are intermediate step diagrams depicting the method for fabricating the semiconductor device according to some implementations.
FIGS. 38, 39, 40, 41, 42, and 43 are intermediate step diagrams depicting the method for fabricating the semiconductor device according to some implementations.

### DETAILED DESCRIPTION

Although terms such as first and second are used to describe various elements or components in the present specification, it goes without saying that these elements or components are not limited by these terms. These terms are only used to distinguish a single element or component from other elements or components. Therefore, it goes without saying that a first element or component referred to below may be a second element or component within the technical idea of the present disclosure.

Further, in this specification, the term "same" does not only mean exactly the same thing, but also includes slight differences that may occur due to process margins, etc. As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

The term "overlap" (or "overlapping", or like terms), as may be used herein, is intended to broadly refer to a first element that intersects with at least a portion of a second element when viewed in a particular direction (e.g., in a third direction Z, perpendicular to an upper surface of a substrate), but does not require that the first and second elements be completely aligned with one another. Components or layers described with reference to "overlap" in a particular direction may be at least partially obstructed by one another when viewed along a line extending in the particular direction. For instance, components or layers described with reference to "overlap" in a particular direction may be positioned such that a line that runs parallel to the particular direction may be positioned such that it intersects at least a portion of each of the components or layers.

The structures defined herein may be defined relative to a first direction X, a second direction Y, and a third direction Z. The first direction X may intersect (e.g., may be perpendicular to) the second direction Y. The third direction Z may intersect (e.g., may be perpendicular to) the first direction X and the second direction Y. The third direction Z may be perpendicular to an upper surface of a substrate. The third direction Z may define a height direction. The terms "upper", "middle", "lower" may refer to relative positions along the third direction Z. It will be appreciated that the directions, positions and relative arrangements described herein are described relative to the structure of the device, and need not imply any particular orientation of the device in use.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

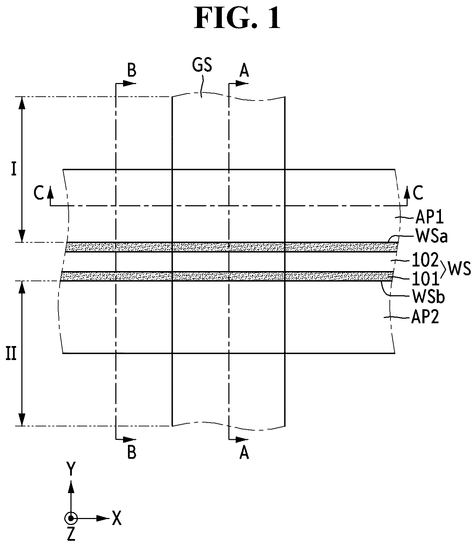

A semiconductor device according to example implementations will be described below referring to FIGS. 1 to 10.

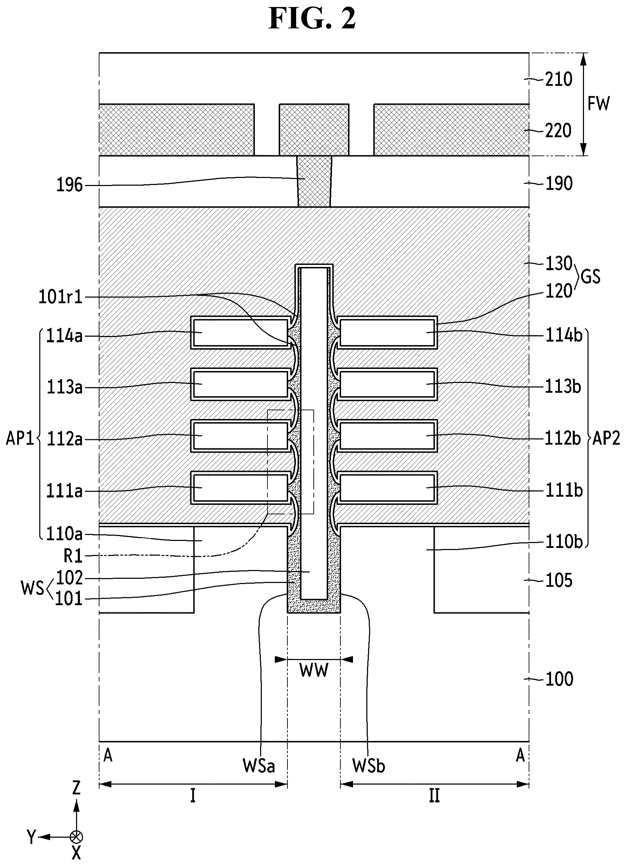

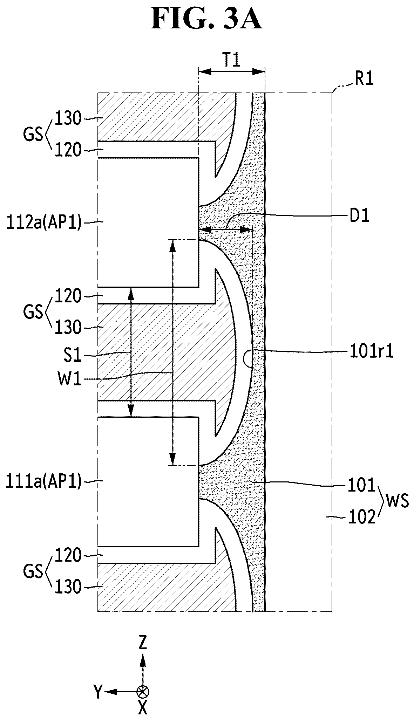

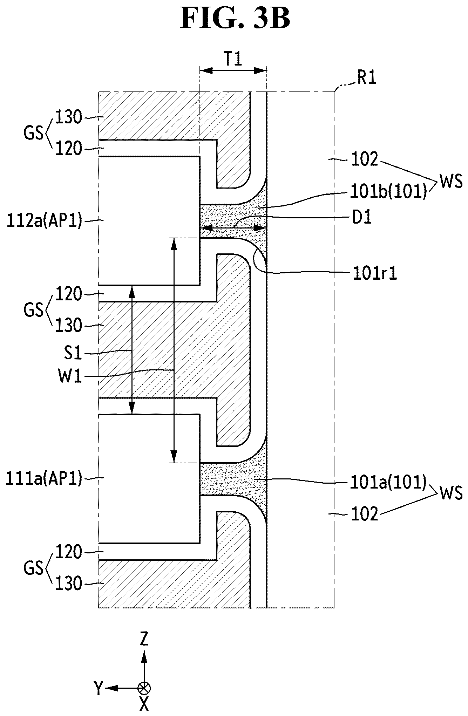

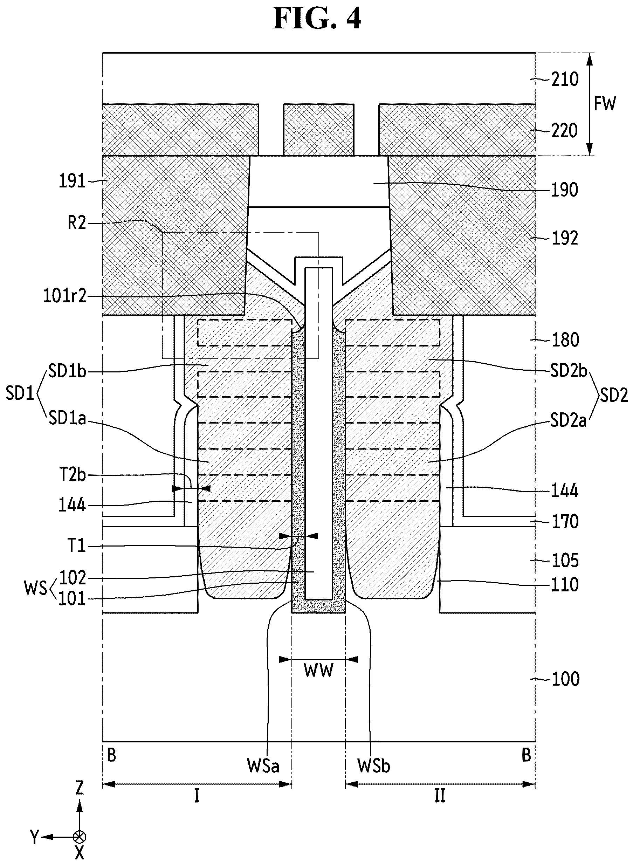

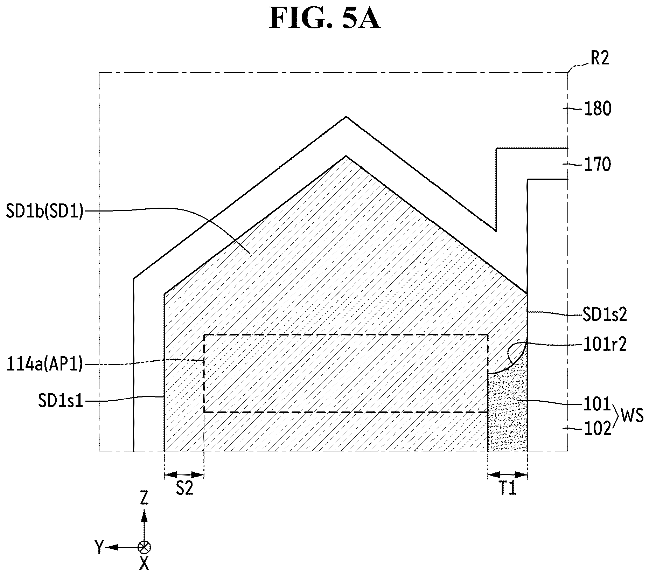

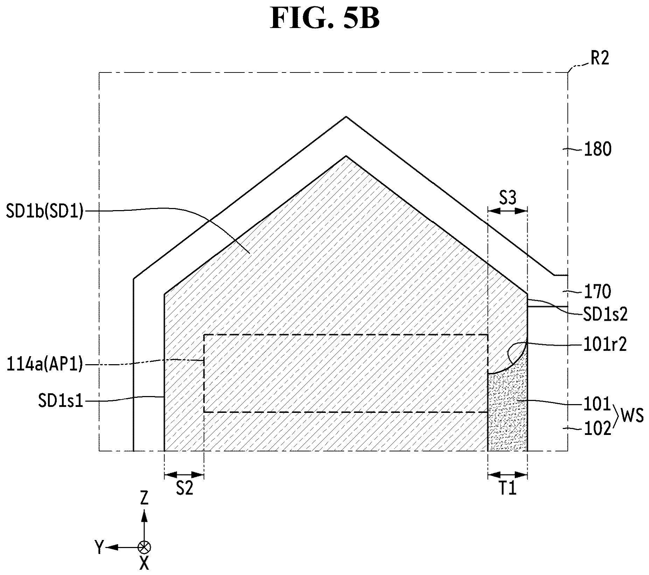

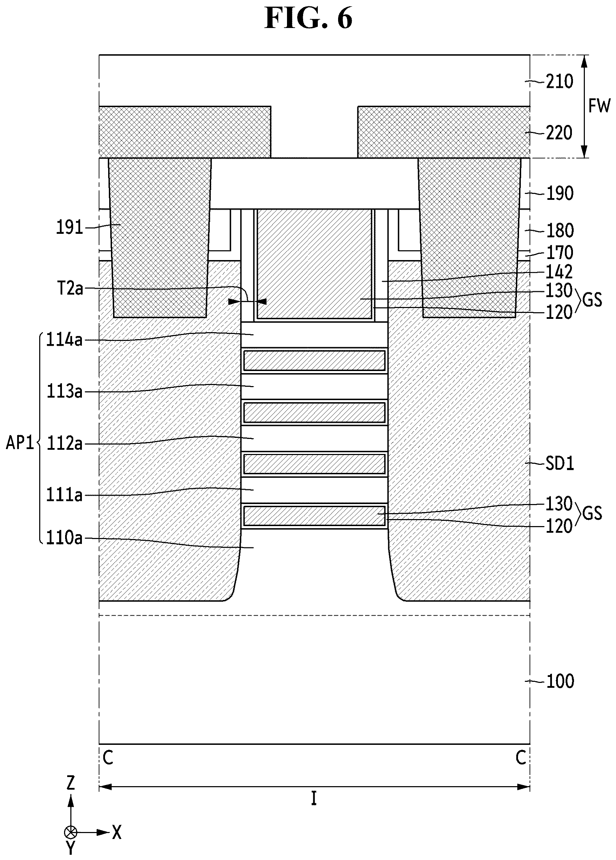

FIG. 1 is a layout diagram for explaining the semiconductor device according to several implementations. FIG. 2 is a cross-sectional view taken along line A-A of FIG. 1. FIGS. 3A and 3B are various enlarged views for explaining a region R1 of FIG. 2. FIG. 4 is a cross-sectional view taken along line B-B of FIG. 1. FIGS. 5A and 5B are various enlarged views for explaining a region R2 of FIG. 4. FIG. 6 is a cross-sectional view taken along line C-C of FIG. 1.

Referring to FIGS. 1 to 6, the semiconductor device according to some implementations includes a first substrate 100, a first active pattern AP1, a second active pattern AP2, a wall structure WS, a field insulating film 105, a gate structure GS, a gate spacer 142, a first epitaxial pattern SD1, a second epitaxial pattern SD2, a spacer pattern 144, an etch stop layer 170, a first interlayer insulating film 180, a second interlayer insulating film 190, a first source/drain contact 191, a second source/drain contact 192, a gate contact 196, and a front wiring structure FW.

The first substrate 100 may be bulk silicon or silicon-on-insulator (SOI). In contrast, the first substrate 100 may be a silicon substrate, or may include other materials, for example, silicon germanium, silicon germanium on insulator (SGOI), indium antimonide, lead telluride, indium arsenide, indium phosphide, gallium arsenide or gallium antimonide. Alternatively, the first substrate 100 may be a base substrate having an epitaxial layer formed thereon. For convenience of explanation, the following description will be given of the first substrate 100 being a silicon substrate.

The first substrate 100 may include a first region I and a second region II. The first region I and the second region II may be regions separated from each other around the wall structure WS. For example, the wall structure WS may extend in a first direction X parallel to an upper surface of the first substrate 100. The wall structure WS may also include a first side surface WSa and a second side surface WSb that run parallel to the upper surface of the first substrate 100 (e.g., in the first direction X) and are opposite to each other in a second direction Y that intersects (e.g., is perpendicular to) the first direction X. The first region I may be a region of the first substrate 100 that is defined on the first side surface WSa of the wall structure WS, and the second region II may be a region of the first substrate 100 that is defined on the second side surface WSb of the wall structure WS.

Transistors of the same conductivity type or different conductivity types may be formed on the first region I and the second region II.

In some implementations, the first substrate 100 may be a (110) semiconductor wafer. The (110) semiconductor wafer refers to a semiconductor wafer having a surface oriented along a (110) crystal plane (e.g., where (110) are Miller indices). For example, the upper surface of the first substrate 100 may include a (110) crystal plane. For instance, the upper surface of the first substrate 100 may be parallel to the (110) crystal plane.

The first active pattern AP1 may be formed on the first region I of the first substrate 100. The first active pattern AP1 may extend (e.g., may extend long) in the first direction X. The first active pattern AP1 may include a plurality of first bridge patterns (e.g., first to fourth sheet patterns 111a to 114a) spaced apart from each other in a third direction Z intersecting (e.g., perpendicular to) the upper surface of the first substrate 100. The first bridge patterns 111a to 114a may be provided as channel regions (e.g., channel patterns) of a multi-bridge channel field-effect transistor (MBCFET^{®}) including a multi-bridge channel. The number of bridge patterns included in the first active pattern AP1 is merely an example, and is not limited to that shown in the drawings.

In some implementations, a first fin pattern 110a may be formed between the first substrate 100 and the first bridge patterns 111a to 114a. The first fin pattern 110a may protrude from the upper surface of the first substrate 100 and extend in the first direction X. The first fin pattern 110a may be formed by etching a part of the first substrate 100, or may be an epitaxial layer grown from the first substrate 100. The first bridge patterns 111a to 114a may be spaced apart from the first fin pattern 110a in the third direction Z.

The second active pattern AP2 may be formed on the second region II of the first substrate 100. The second active pattern AP2 may extend (e.g., may extend long) in the first direction X. The second active pattern AP2 may include a plurality of second bridge patterns (e.g., fifth to eighth sheet patterns 111b to 114b) spaced apart from each other in the third direction Z intersecting the upper surface of the first substrate 100. The second bridge patterns 111b to 114b may be provided as channel regions of MBCFET^{®} including a multi-bridge channel. The number of bridge patterns included in the second active pattern AP2 is merely an example and is not limited to that shown.

In some implementations, a second fin pattern 110b may be formed between the first substrate 100 and the second bridge patterns 111b to 114b. The second fin pattern 110b may protrude from the upper surface of the first substrate 100 and extend in the first direction X. The second fin pattern 110b may be formed by etching a part of the first substrate 100 or may be an epitaxial layer grown from the first substrate 100. The second bridge patterns 111b to 114b may be spaced apart from the second fin pattern 110b in the third direction Z.

The first active pattern AP1 and the second active pattern AP2 may be located at the same level as each other. In this specification, the expression "located at the same level" means location at the same height on the basis of (e.g., relative to) the upper surface of the first substrate 100. For example, a height may refer to a relative position along the third direction Z. In the present example, as shown, the first sheet pattern 111a and the fifth sheet pattern 111b may be located at the same height as each other. For instance, each of the first bridge patterns 111a-114a of the first active pattern AP1 may be located at the same height as a corresponding one of the second bridge patterns 111b-114b of the second active pattern AP2.

Each of the first active pattern AP1 and the second active pattern AP2 may be formed at the same level as each other. In this specification, the expression "formed at the same level" means formation by the same fabricating process. For instance, two patterns formed "at the same level" may be formed of the same material, that has been etched to form the patterns. For example, the first sheet pattern 111a and the fifth sheet pattern 111b may have the same material and/or the same material configuration.

Each of the first active pattern AP1 and the second active pattern AP2 may include silicon (Si) or germanium (Ge) which is an elemental semiconductor material. Alternatively, each of the first active pattern AP1 and the second active pattern AP2 may include a compound semiconductor, for example, a group IV-IV compound semiconductor or a group III-V compound semiconductor. The group IV-IV compound semiconductor may be, for example, a binary compound or a ternary compound containing at least two or more of carbon (C), silicon (Si), germanium (Ge), and tin (Sn), or a compound obtained by doping these elements with a group IV element. The group III-V compound semiconductor may be one of a binary compound, a ternary compound or a quaternary compound formed by combining at least one of aluminum (Al), gallium (Ga), and indium (In) which are group III elements, with at least one of phosphorus (P), arsenic (As), and antimony (Sb) which are group V elements. For convenience of explanation, in the following explanation, each of the first active pattern AP1 and the second active pattern AP2 will be described as a silicon (Si) pattern.

In some implementations, each of the first active pattern AP1 and the second active pattern AP2 may include a (110) crystal plane. For example, the upper surfaces of each of the first bridge patterns 111a to 114a and the upper surfaces of each of the second bridge patterns 111b to 114b may include a (110) crystal plane. For example, the upper surfaces of each of the first bridge patterns 111a to 114a and the upper surfaces of each of the second bridge patterns 111b to 114b may be parallel to the (110) crystal plane.

The wall structure WS may be disposed between the first region I and the second region II. The wall structure WS may extend (e.g., may extend long) in the first direction X to separate the first active pattern AP1 and the second active pattern AP2. In some implementations, the first active pattern AP1 may be in contact with a first side surface WSa of the wall structure WS, and the second active pattern AP2 may be in contact with a second side surface WSb of the wall structure WS. The first active pattern AP1 and the second active pattern AP2 separated by the wall structure WS may be provided as a channel region of a forksheet field effect transistor (forksheet FET).

The wall structure WS may include an insulating material, for example, but is not limited to, at least one of silicon oxide, silicon nitride, silicon oxynitride, silicon oxycarbide, silicon boron nitride, silicon boron carbonitride, silicon oxycarbonitride, a low dielectric constant (low-k) material (e.g., a material having a dielectric constant smaller than silicon oxide), or combinations thereof. The wall structure WS may be provided as an insulating wall (so-called dielectric wall scheme (DWS)) in the forksheet field effect transistor.

The wall structure WS may include a liner film 101 and a wall pattern 102 that are stacked in order. The wall pattern 102 may extend (e.g., may extend long) in the first direction X. The liner film 101 may extend along the lower surface and the side surface of the wall pattern 102. The liner film 101 may have an etch selectivity with respect to the wall pattern 102. For example, the wall pattern 102 may include a first insulating material, and the liner film 101 may include a second insulating material different from the first insulating material. As an example, the liner film 101 may include a silicon nitride film, and the wall pattern 102 may include at least one of a silicon oxynitride film, a silicon oxycarbide film, or a low dielectric constant (low-k material) film.

In some implementations, a width WW of the wall structure WS in the second direction Y may be about 20 nm to about 25 nm. In some implementations, a thickness T1 of the liner film 101 may be about 5 nm to about 10 nm. Here, the thickness T1 of the liner film 101 refers to a maximum thickness of the liner film 101.

The field insulating film 105 may be formed on the first region I and the second region II. The field insulating film 105 may cover at least a part of the side surface of the first fin pattern 110a and at least a part of the side surface of the second fin pattern 110b. Although the upper surface of the field insulating film 105 is only shown in FIG. 2 as being coplanar with the upper surface of the first fin pattern 110a and the upper surface of the second fin pattern 110b, this is merely an example. Unlike the shown example, the upper surface of the field insulating film 105 may be formed to be lower than the upper surface of the first fin pattern 110a and the upper surface of the second fin pattern 110b, or may be formed to be higher than the upper surface of the first fin pattern 110a and the upper surface of the second fin pattern 110b.

The field insulating film 105 may include, but is not limited to, at least one of silicon oxide, silicon nitride, silicon oxynitride, or a combination thereof. As an example, the field insulating film 105 may include a silicon oxide film.

In some implementations, the lower surface of the wall structure WS may be disposed to be coplanar with the lower surface of the field insulating film 105. That is, the height of the lower surface of the wall structure WS may be the same as the height of the lower surface of the field insulating film 105.

The gate structure GS may be formed on the first active pattern AP1 and the second active pattern AP2. The gate structure GS may intersect the first active pattern AP1 and the second active pattern AP2. For example, the gate structure GS may extend (e.g., may extend long) in the second direction Y. Each of the first bridge patterns 111a to 114a and each of the second bridge patterns 111b to 114b may extend in the first direction X and penetrate the gate structure GS.

The gate structure GS may include a gate dielectric film 120 and a gate electrode 130.

The gate dielectric film 120 may be stacked on the first active pattern AP1 and the second active pattern AP2. The gate dielectric film 120 may be interposed between the first active pattern AP1 and the gate electrode 130, and between the second active pattern AP2 and the gate electrode 130. For example, the gate dielectric film 120 may conformally extend along the periphery of each of the first bridge patterns 111a to 114a and the periphery of each of the second bridge patterns 111b to 114b. The gate dielectric film 120 may further extend along the upper surface of the first fin pattern 110a, the upper surface of the second fin pattern 110b, and the upper surface of the field insulating film 105.

The gate dielectric film 120 may include, for example, at least one of silicon oxide, silicon oxynitride, silicon nitride or a high dielectric constant material (e.g., a material having a dielectric constant greater than that of silicon oxide). The high dielectric constant material may include, for example, but is not limited to, at least one of hafnium oxide (HfO₂), zirconium oxide (ZrO₂), lanthanum oxide (La₂O₃), aluminum oxide (Al₂O₃), titanium oxide (TiO₂), strontium titanium oxide (SrTiO₃), lanthanum aluminum oxide (LaAlO₃), yttrium oxide (Y₂O₃), hafnium oxynitride (HfOₓN_{y}), zirconium oxynitride (ZrOₓN_{y}), lanthanum oxynitride (LaxOₓN_{y}), aluminum oxynitride (Al₂OₓN_{y}), titanium oxynitride (TiOₓN_{y}), strontium titanium oxynitride (SrTiOₓN_{y}), lanthanum aluminum oxynitride (LaAlOₓN_{y}), yttrium oxynitride (Y₂OₓN_{y}) or combinations thereof.

The semiconductor device according to some implementations may include an NC (Negative Capacitance) FET that uses a negative capacitor. For example, the gate dielectric film 120 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and the capacitance of each capacitor has a positive value, the overall capacitances decrease from the capacitance of each of the individual capacitors. On the other hand, if at least one of the capacitances of two or more capacitors connected in series has a negative value, the overall capacitance may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. Using the increased overall capacitance values, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). The type of dopant included in the ferroelectric material film may vary, depending on which ferroelectric material is included in the ferroelectric material film.

When the ferroelectric material film includes hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 at% to 10 at% silicon. When the dopant is yttrium (Y), the ferroelectric material film may include 2 at% to 10 at% yttrium. When the dopant is gadolinium (Gd), the ferroelectric material film may include 1 at% to 7 at% gadolinium. When the dopant is zirconium (Zr), the ferroelectric material film may include 50 at% to 80 at% zirconium.

The paraelectric material film may have paraelectric properties. The paraelectric material film may include, for example, at least one of a silicon oxide and a metal oxide having a high dielectric constant. The metal oxide included in the paraelectric material film may include, for example, but is not limited to, at least one of hafnium oxide, zirconium oxide, and aluminum oxide.

The ferroelectric material film and the paraelectric material film may include the same material. The ferroelectric material film has ferroelectric properties, but the paraelectric material film may not have the ferroelectric properties. For example, when the ferroelectric material film and the paraelectric material film include hafnium oxide, a crystal structure of hafnium oxide included in the ferroelectric material film is different from a crystal structure of hafnium oxide included in the paraelectric material film.

The ferroelectric material film may have a thickness having the ferroelectric properties. The thickness of the ferroelectric material film may be, for example, but is not limited to, 0.5 to 10 nm. Since a critical thickness that exhibits the ferroelectric properties may differ for each ferroelectric material, the thickness of the ferroelectric material film may vary depending on the ferroelectric material.

As an example, the gate dielectric film 120 may include one ferroelectric material film. As another example, the gate dielectric film 120 may include a plurality of ferroelectric material films spaced apart from one another. The gate dielectric film 120 may have a stacked layer structure in which a plurality of ferroelectric material films and a plurality of paraelectric material films are alternately stacked.

The gate electrode 130 may be stacked on the gate dielectric film 120. The gate dielectric film 120 may extend (e.g., may extend long) in the second direction Y. Although the gate electrode 130 is only shown as being a single film, this is only an example, and the gate electrode 130 may be multi-layer films in which the plurality of conductive films are stacked. For example, the gate electrode 130 may include a work function adjusting film that adjusts a work function, and a filling conductive film that fills a space formed by the work function adjusting film. The work function adjusting film may include, for example, but is not limited to, at least one of TiN, TaN, TiC, TaC, TiAlC or combinations thereof. The filling conductive film may include, for example, but is not limited to, W or Al.

In some implementations, the height of the upper surface of the gate electrode 130 may be higher than the height of the uppermost portion of the wall structure WS. In this case, the first active pattern AP1 and the second active pattern AP2 may share one gate electrode 130.

In some implementations, as shown in FIG. 2, a part of the liner film 101 may be interposed between the first active pattern AP1 and the wall pattern 102 and/or between the second active pattern AP2 and the wall pattern 102 in the second direction Y.

In some implementations, a part of the gate structure GS may be interposed between the first active pattern AP1 and the wall structure WS and/or between the second active pattern AP2 and the wall structure WS in the second direction Y. For example, as shown in FIGS. 3A and 3B, the liner film 101 may include a first recess 101r1 recessed toward the wall pattern 102. A plurality of first recesses 101r1 may be located on the first side surface WSa of the wall structure WS. Each first recess 101r1 may be located (e.g., centered) at a height between a corresponding pair of adjacent first bridge patterns 111a to 114a or between the lowermost first bridge pattern 111a and the first fin pattern 110a. A part of the first recess(es) 101r1 may not overlap each (e.g., any) of the first bridge patterns 111a to 114a in the second direction Y. Another part of the first recess(es) 101r1 may overlap at least some of the first bridge patterns 111a to 114a in the second direction Y. As an example, a width W1 of one first recess 101r1 in the third direction Z may be larger than a distance S1 by which the first sheet pattern 111a and the second sheet pattern 112a are spaced apart in the third direction Z. A part of the gate structure GS may fill at least a part of the first recess 101r1. First recesses 101r1 may be located on each of the first side surface WSa and the second side surface WSb of the wall structure WS. Corresponding pairs of first recesses 101r1 may be located at corresponding heights on opposite sides of the wall structure WS. The wall structure WS may be symmetrical about an axis running along the first direction X and the second direction Y.

In some implementations, a part of the gate electrode 130 may be interposed between each of the first bridge patterns 111a to 114a and the wall structure WS, and/or between each of the second bridge patterns 111b to 114b and the wall structure WS in the second direction Y. In this case, the gate electrode 130 may improve gate controllability, by at least partially surrounding the four sides of each of the first bridge patterns 111a to 114a and/or the four sides of each of the second bridge patterns 111b to 114b.

In some implementations, the first recess(es) 101r1 opposite to the first active pattern AP1 (e.g., on the second side surface WSb) may include a concave side recessed toward the first active pattern AP1 (e.g., toward the left side in FIG. 2), and the first recess(es) 101r1 opposite to the second active pattern AP2 (e.g., on the first side surface WSa) may include a concave side recessed toward the first active pattern AP2 (e.g., toward the right side in FIG. 2).

In some implementations, as shown in FIG. 3A, a depth D1 of the first recess 101r1 in the second direction Y may be smaller than the thickness T1 of the liner film 101 in the second direction Y. In this case, the gate structure GS may be spaced apart from the wall pattern 102 in the second direction Y. In some implementations, a difference between the thickness T1 of the liner film 101 and the depth D1 of the first recess 101r1 may be 1 nm or more. As an example, when the thickness T1 of the liner film 101 is about 5 nm, the depth D1 of the first recess 101r1 may be about 4 nm or less.

In some implementations, as shown in FIG. 3B, the depth D1 of the first recess 101r1 in the second direction Y may be equal to the thickness T1 of the liner film 101 in the second direction Y. In this case, the gate structure GS may be in contact with the wall pattern 102 in the second direction Y. The liner film 101 may also form a plurality of insulating patterns separated in the third direction Z. As an example, the liner film 101 may include a first liner pattern 101a and a second liner pattern 101b that are separated by the first recess 101r1 between the first sheet pattern 111a and the second sheet pattern 112a. The first liner pattern 101a may be interposed between the first sheet pattern 111a and the wall structure WS in the second direction Y. The second liner pattern 101b may be interposed between the second sheet pattern 112a and the wall structure WS in the second direction Y. Accordingly, separate liner patterns may be provided between each sheet pattern and the wall structure WS.

The gate spacer 142 may extend along a side surface of the gate structure GS. A gate spacer 142 may be located on each side surface (e.g., on opposite side surfaces) of the gate structure GS in the first direction X. In some implementations, a part of the gate dielectric film 120 may be interposed between the gate electrode 130 and the gate spacer 142. For example, as shown in FIG. 6, the gate dielectric film 120 may further extend along at least a part of an inner side surface of the gate spacer 142. Such a gate dielectric film 120 may be formed by, but is not limited to, a replacement process.

The gate spacer 142 may include an insulating material, for example, but is not limited to, at least one of silicon nitride, silicon oxynitride, silicon oxycarbide, silicon boron nitride, silicon boron carbonitride, silicon oxycarbonitride or combinations thereof. As an example, the gate spacer 142 may include a silicon nitride film.

The first epitaxial pattern SD1 may be formed on at least one side (e.g., both sides) of the gate structure GS. The first epitaxial pattern SD1 may be formed on a side surface of the gate spacer 142. The first epitaxial pattern SD1 may be connected to the first active pattern AP1 in the first direction X. For example, each of the first bridge patterns 111a to 114a may penetrate the gate structure GS and the gate spacer 142, and be connected to the first epitaxial pattern SD1. The first epitaxial pattern SD1 may be electrically separated from the gate electrode 130 by the gate spacer 142 and/or the gate dielectric film 120.

The first epitaxial pattern SD1 may include an epitaxial layer. For example, the first epitaxial pattern SD1 may be formed by an epitaxial growth process that uses the first substrate 100 and/or the first active pattern AP1 as a seed layer. The first epitaxial pattern SD1 may be provided as a source/drain region of a field effect transistor formed on the first region I.

The second epitaxial pattern SD2 may be formed on at least one side (e.g., both sides) of the gate structure GS. The second epitaxial pattern SD2 may be formed on a side surface of the gate spacer 142. The second epitaxial pattern SD2 may be connected to the second active pattern AP2 in the first direction X. For example, each of the second bridge patterns 111b to 114b may penetrate the gate structure GS and the gate spacer 142, and be connected to the second epitaxial pattern SD2. The second epitaxial pattern SD2 may be electrically separated from the gate electrode 130 by the gate spacer 142 and/or the gate dielectric film 120.

The second epitaxial pattern SD2 may include an epitaxial layer. For example, the second epitaxial pattern SD2 may be formed by an epitaxial growth process for using the first substrate 100 and/or the second active pattern AP2 as a seed layer. The second epitaxial pattern SD2 may be provided as a source/drain region of a field effect transistor formed on the second region II.

As described herein, an epitaxial pattern may be a pattern formed through an epitaxial growth process. An epitaxial pattern may possess a crystal structure and/or a crystallographic orientation that is aligned with or substantially related to that of the seed layer. The material composition of the epitaxial pattern may be the same as the seed layer (homoepitaxy), or it may be different (heteroepitaxy). An epitaxial pattern may have a substantially single-crystal structure, though it might include crystalline defects, polycrystalline, or amorphous regions. As an example, the first epitaxial pattern SD1 may have a crystal structure and/or crystallographic orientation that is aligned with that of the first substrate 100 and/or the first active pattern AP1. Similarly, the second epitaxial pattern SD2 may have a crystal structure and/or crystallographic orientation that is aligned with that of the first substrate 100 and/or the second active pattern AP2.

When the first region I and/or the second region II are NFET regions, the first epitaxial pattern SD1 and/or the second epitaxial pattern SD2 may include n-type impurities (e.g., phosphorus (P), antimony (Sb) or arsenic (As)) or impurities for preventing diffusion of the n-type impurities. In some implementations, when the first region I and/or the second region II are NFET regions, the first epitaxial pattern SD1 and/or the second epitaxial pattern SD2 may further include a tensile stress material. A tensile stress material may be a material that applies tensile stress (or tensile strain) to an adjacent region (e.g., due to intrinsic properties and/or lattice mismatch). As an example, when the first active pattern AP1 and/or the second active pattern AP2 are silicon (Si) patterns, the first epitaxial pattern SD1 and/or the second epitaxial pattern SD2 may include a material (e.g., silicon carbide (SiC)) having a smaller lattice constant than silicon (Si). More generally, the first epitaxial pattern SD1 and/or the second epitaxial pattern SD2 may include a material having a smaller lattice constant than a material (e.g., a semiconductor material) of the first active pattern AP1 and/or the second active pattern AP2.

When the first region I and/or the second region II are PFET regions, the first epitaxial pattern SD1 and/or the second epitaxial pattern SD2 may include p-type impurities (e.g., boron (B), indium (In), gallium (Ga) or aluminum (Al)) or impurities for preventing diffusion of the p-type impurities. In some implementations, when the first region I and/or the second region II are PFET regions, the first epitaxial pattern SD1 and/or the second epitaxial pattern SD2 may further include a compressive stress material. A compressive stress material may be a material that applies compressive stress (or compressive strain) to an adjacent region (e.g., due to intrinsic properties and/or lattice mismatch). As an example, when the first active pattern AP1 and/or the second active pattern AP2 are silicon (Si) patterns, the first epitaxial pattern SD1 and/or the second epitaxial pattern SD2 may include a material (e.g., silicon germanium (SiGe)) having a larger lattice constant than silicon (Si). More generally, the first epitaxial pattern SD1 and/or the second epitaxial pattern SD2 may include a material having a larger lattice constant than a material (e.g., a semiconductor material) of the first active pattern AP1 and/or the second active pattern AP2.

The wall structure WS may extend (e.g., may extend long) in the first direction X to separate the first epitaxial pattern SD1 and the second epitaxial pattern SD2. For example, the first epitaxial pattern SD1 may be in contact with the first side surface WSa of the wall structure WS, and the second epitaxial pattern SD2 may be in contact with the second side surface WSb of the wall structure WS.

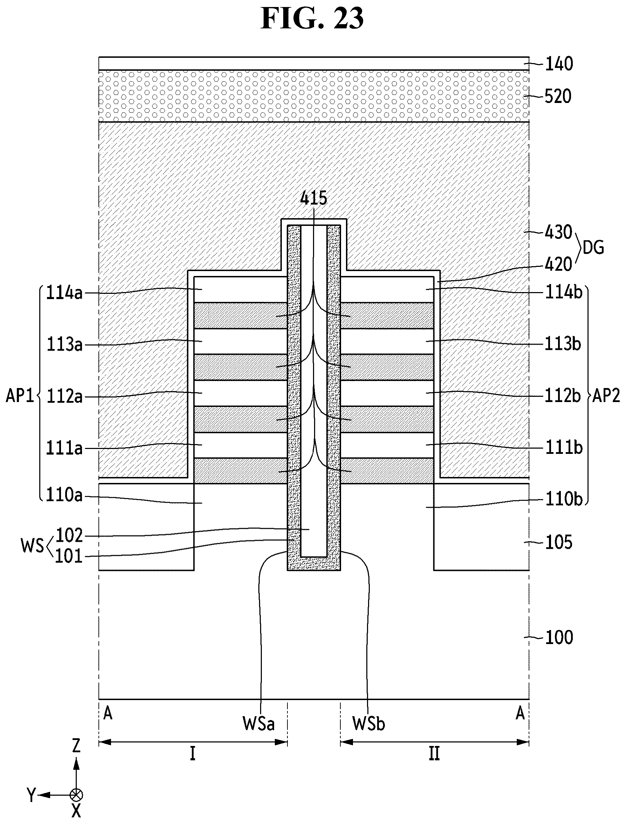

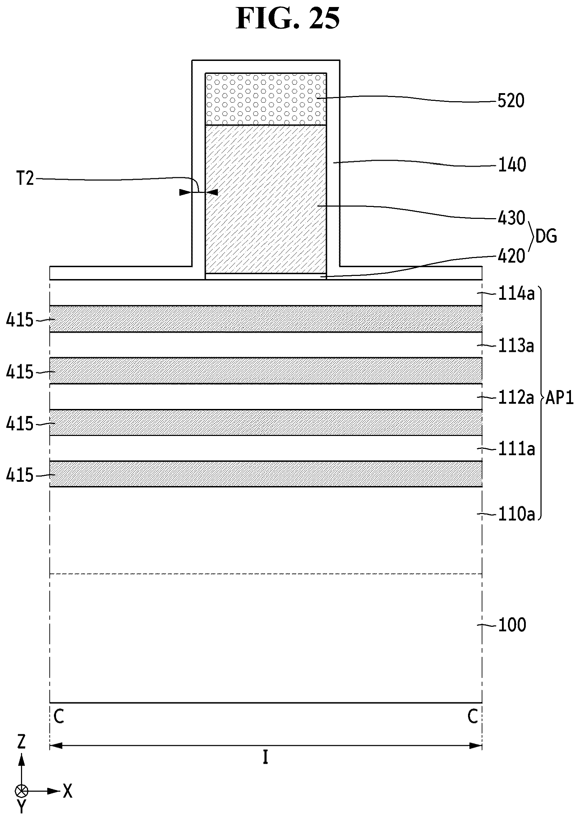

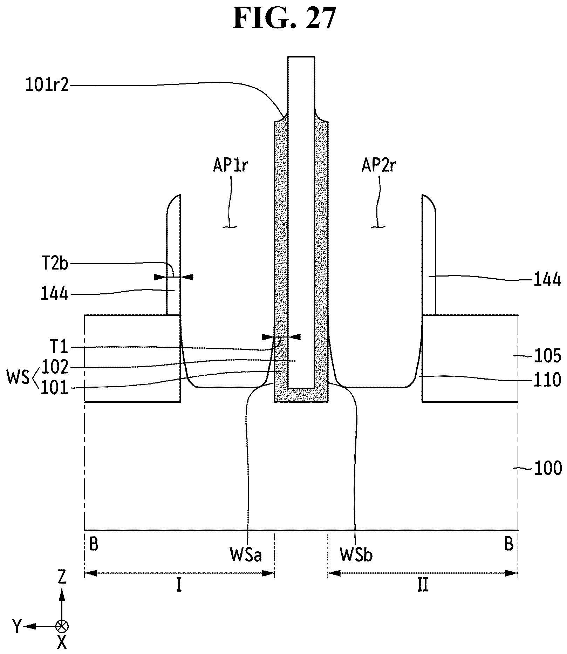

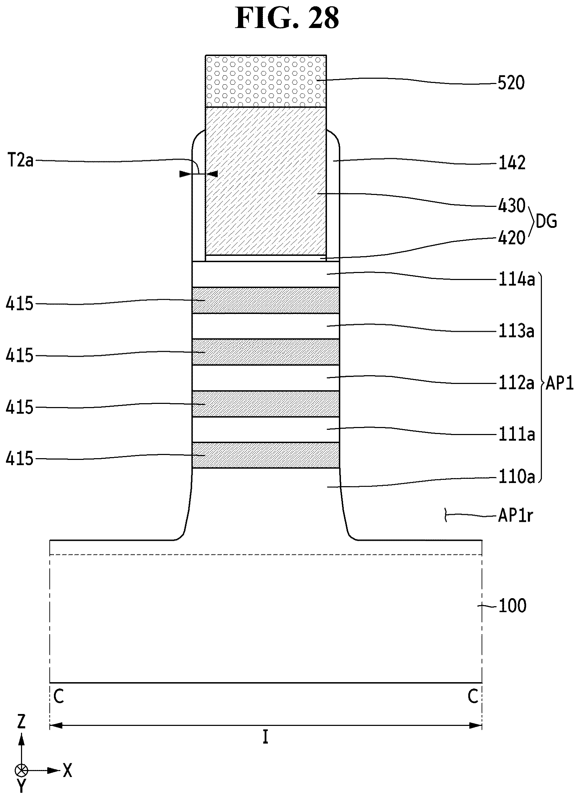

In some implementations, as shown in FIG. 4, a part of the liner film 101 may be interposed between the first epitaxial pattern SD1 and the wall pattern 102 and/or between the second epitaxial pattern SD2 and the wall pattern 102 in the second direction Y. In some implementations, as shown in FIG. 4, the height of the uppermost portion of the liner film 101 may be higher than the height of the lowermost side of the first sheet pattern 111a and/or the height of the lowermost side of the fifth sheet pattern 111b. In this case, the liner film 101 may effectively prevent short between the first epitaxial pattern SD1 and the second epitaxial pattern SD2 by avoiding or reducing a disappearance (e.g., etching) of the wall pattern 102 in the process of forming the first epitaxial pattern SD1 and/or the second epitaxial pattern SD2. This will be explained in more detail below in the explanation of FIGS. 23 to 30.

In some implementations, as shown in FIG. 4, the upper surface of the liner film 101 interposed between the first epitaxial pattern SD1 and the wall pattern 102 and/or between the second epitaxial pattern SD2 and the wall pattern 102 in the second direction Y may include a second recess 101r2 that is recessed downward. As the second recess 101r2 is formed, the height of the uppermost portion of the liner film 101 may be formed to be lower than the height of the uppermost portion of the wall pattern 102 in FIG. 4. For example, the height of the uppermost portion of the second recess 101r2 may be lower than the height of the uppermost portion of the wall pattern 102.

In some implementations, the second recess 101r2 may include a concave side that is recessed downward (e.g., the concave side may at least partially face upward). In some implementations, the height of the second recess 101r2 may decrease as it goes away from the wall pattern 102. For example, as shown in FIG. 4, the height of the side surface of the liner film 101 spaced apart from the wall pattern 102 may be lower than the height of the side surface of the liner film 101 adjacent to the wall pattern 102.

In some implementations, the height of the uppermost portion of the second recess 101r2 may be equal to or less than the height of the uppermost portion of the first active pattern AP1 (e.g., the uppermost side of the fourth sheet pattern 114a) and/or the uppermost portion of the second active pattern AP2 (e.g., the uppermost side of the eighth sheet pattern 114b). In this case, a shadowing effect caused by the gate spacer 142 may be effectively prevented. This will be explained in more detail below in the explanation of FIGS. 23 to 28.

In some implementations, the height of the lowermost portion of the second recess 101r2 may be equal to or greater than the height of the lowermost side of the uppermost bridge pattern (e.g., the fourth sheet pattern 114a and/or the eighth sheet pattern 114b). In this case, the liner film 101 may effectively reduce the disappearance (e.g., removal) of the wall pattern 102 in the process of forming the first epitaxial pattern SD1 and/or the second epitaxial pattern SD2.

In some implementations, the upper portion of the first epitaxial pattern SD1 and/or the upper portion of the second epitaxial pattern SD2 may be in contact with the wall pattern 102. In some implementations, the first epitaxial pattern SD1 and/or the second epitaxial pattern SD2 may fill at least a part of the second recess 101r2.

In some implementations, the thickness (e.g., T1 of FIG. 4) of the liner film 101 interposed between the first epitaxial pattern SD1 and the wall pattern 102 and/or between the second epitaxial pattern SD2 and the wall pattern 102 may be equal to or greater than a thickness (e.g., T2a of FIG. 6) of the gate spacer 142 in the first direction X. As an example, when the thickness T1 of the liner film 101 is about 5 nm, the thickness T2a of the gate spacer 142 may be about 5 nm or less. In this case, the shadowing effect caused by the gate spacer 142 may be effectively prevented. This will be explained in more detail below in the explanation of FIGS. 23 to 28.

The spacer pattern 144 may be formed on the field insulating film 105. The spacer pattern 144 may extend along a part of a side surface of the first epitaxial pattern SD1 intersecting the second direction Y and/or a part of a side surface of the second epitaxial pattern SD2 intersecting the second direction Y. The first epitaxial pattern SD1 may be interposed between the wall structure WS and the spacer pattern 144 in the second direction Y. The second epitaxial pattern SD2 may be interposed between the wall structure WS and the spacer pattern 144 in the second direction Y.

The height of the uppermost portion of the spacer pattern 144 may be lower than the height of the uppermost portion of the first epitaxial pattern SD1. For example, the first epitaxial pattern SD1 may include a first lower pattern SD1a and a first upper pattern SD1b. The first lower pattern SD1a may be a lower portion of the first epitaxial pattern SD1 interposed between the spacer pattern 144 and the wall structure WS. The first upper pattern SD1b may be an upper portion of the first epitaxial pattern SD1 formed to be higher than the uppermost portion of the spacer pattern 144.

The height of the uppermost portion of the spacer pattern 144 may be lower than the height of the uppermost portion of the second epitaxial pattern SD2. For example, the second epitaxial pattern SD2 may include a second lower pattern SD2a and a second upper pattern SD2b. The second lower pattern SD2a may be a lower portion of the second epitaxial pattern SD2 interposed between the spacer pattern 144 and the wall structure WS. The second upper pattern SD2b may be an upper portion of the second epitaxial pattern SD2 formed to be higher than the uppermost portion of the spacer pattern 144.

The gate spacer 142 and the spacer pattern 144 may be formed at the same level (e.g., at the same time) as each other. For example, the gate spacer 142 and the spacer pattern 144 may have the same material and/or material composition as each other.

In some implementations, the thickness (e.g., T2a of FIG. 6) of the gate spacer 142 in the first direction X may be equal to a thickness (e.g., T2b of FIG. 4) of the spacer pattern 144 in the second direction Y.

In some implementations, the thickness (e.g., T1 of FIG. 4) of the liner film 101 interposed between the first epitaxial pattern SD1 and the wall pattern 102 and/or between the second epitaxial pattern SD2 and the wall pattern 102 may be equal to or greater than the thickness (e.g., T2b of FIG. 4) of the spacer pattern 144 in the second direction Y. As an example, when the thickness T1 of the liner film 101 is about 5 nm, the thickness T2b of the spacer pattern 144 may be about 5 nm or less.

In some implementations, since each of the first substrate 100, the first active pattern AP1, and/or the second active pattern AP2 includes the (110) crystal plane, each of the first epitaxial pattern SD1 and/or the second epitaxial pattern SD2 may have a form in which a lateral growth is restricted in comparison with a vertical growth. Here, the vertical growth means growth of the epitaxial layer along the third direction Z, and the lateral growth means growth of the epitaxial layer along the second direction Y. For example, as shown in FIG. 4, each of the first upper pattern SD1b and/or the second upper pattern SD2b may have a form in which the vertical growth predominates over the lateral growth.

In some implementations, the lateral growth of the first epitaxial pattern SD1 and/or the lateral growth of the second epitaxial pattern SD2 may be controlled to be equal to or less than the thickness T1 of the liner film 101 in the second direction Y. For example, as shown in FIGS. 5A and 5B, the first upper pattern SD1b may include an outer side surface SD1s1 spaced apart from the wall structure WS, and an inner side surface SD1s2 opposite to the wall structure WS. The outer side surface SD1s1 may extend along a direction that intersects the second direction Y (e.g., the first direction X). At this time, a distance S2 by which the outer side surface SD1s1 of the first upper pattern SD1b is spaced apart from the first active pattern AP1 (e.g., the fourth sheet pattern 114a) in the second direction Y may be equal to or less than the thickness T1 of the liner film 101 interposed between the first upper pattern SD1b and the wall pattern 102. As an example, when the thickness T1 of the liner film 101 is about 5 nm, the lateral growth thickness (e.g., S2) of the first upper pattern SD1b may be about 5 nm or less. In this case, even if the wall pattern 102 disappears, a short between the first epitaxial pattern SD1 and the second epitaxial pattern SD2 may be effectively prevented.

In some implementations, the height of the uppermost portion of the wall pattern 102 may be equal to or greater than the height of the upper surface of the first epitaxial pattern SD1 adjacent to the wall structure WS (e.g., a portion of the upper surface of the first epitaxial pattern SD1 that is adjacent to the wall structure WS) and/or the height of the upper surface of the second epitaxial pattern SD2 adjacent to the wall structure WS (e.g., a portion of the upper surface of the second epitaxial pattern SD2 that is adjacent to the wall structure WS). For example, as shown in FIG. 5A, the height of the uppermost portion of the wall pattern 102 may be higher than the height of the uppermost portion of the inner side surface SD1s2 of the first upper pattern SD1b.

In some implementations, the height of the uppermost portion of the wall pattern 102 may be equal to or less than the height of the upper surface of the first epitaxial pattern SD1 adjacent to the wall structure WS (e.g., a portion of the upper surface of the first epitaxial pattern SD1 that is adjacent to the wall structure WS) and/or the height of the upper surface of the second epitaxial pattern SD2 adjacent to the wall structure WS (e.g., a portion of the upper surface of the second epitaxial pattern SD2 that is adjacent to the wall structure WS). For example, as shown in FIG. 5B, the height of the uppermost portion of the wall pattern 102 may be lower than the height of the uppermost portion of the inner side surface SD1s2 of the first upper pattern SD1b.

In some implementations, a distance S3 by which the inner side surface SD1s2 of the first upper pattern SD1b (e.g., at a portion of the first epitaxial pattern SD1 above the liner film 101) is spaced apart from the first active pattern AP1 (e.g., the fourth sheet pattern 114a) in the second direction Y may be equal to or less than the thickness T1 of the liner film 101 interposed between the first upper pattern SD1b and the wall pattern 102. As an example, when the thickness T1 of the liner film 101 is about 5 nm, the lateral growth thickness (e.g., S3) of the first upper pattern SD1b may be about 5 nm or less. In this case, even if the wall pattern 102 disappears, a short between the first epitaxial pattern SD1 and the second epitaxial pattern SD2 may be effectively prevented.

The etch stop layer 170 may cover the first epitaxial pattern SD1 and the second epitaxial pattern SD2. For example, the etch stop layer 170 may conformally extend along the profiles of the surface of the first epitaxial pattern SD1 and the surface of the second epitaxial pattern SD2. The etch stop layer 170 may be provided as an etch stop layer in an etching process for forming the first source/drain contact 191 and the second source/drain contact 192. The etch stop layer 170 may include, for example, but is not limited to, at least one of silicon nitride (SiN), silicon oxynitride (SiON), silicon oxycarbonitride (SiOCN), silicon boron nitride (SiBN), silicon oxyboronitride (SiOBN), silicon oxycarbide (SiOC) or combinations thereof.

The first interlayer insulating film 180 may be formed on the etch stop layer 170. The first interlayer insulating film 180 may be formed to fill a space on the side surface of the gate structure GS. The second interlayer insulating film 190 may be formed on the gate structure GS and the first interlayer insulating film 180.

Each of the first interlayer insulating film 180 and the second interlayer insulating film 190 may include, for example, but are not limited to, at least one of silicon oxide, silicon nitride, silicon oxynitride, silicon oxycarbide, silicon boron nitride, silicon boron carbonitride, silicon oxycarbonitride, and a low dielectric constant material having a lower dielectric constant than silicon oxide. The low dielectric constant material may include, for example, but is not limited to, at least one of FOX (Flowable Oxide), TOSZ (Torene SilaZene), USG (Undoped Silica Glass), BSG (Borosilica Glass), PSG (PhosphoSilica Glass), BPSG (BoroPhosphoSilica Glass), PETEOS (Plasma Enhanced Tetra Ethyl Ortho Silicate), FSG (Fluoride Silicate Glass), CDO (Carbon Doped silicon Oxide), Xerogel, Aerogel, Amorphous Fluorinated Carbon, OSG (Organo Silicate Glass), Parylene, BCB (bis-benzocyclobutenes), SiLK, polyimide, porous polymeric material, and combinations thereof.

The first source/drain contact 191 may be electrically connected to the first epitaxial pattern SD1. For example, the first source/drain contact 191 may penetrate the first interlayer insulating film 180 and the second interlayer insulating film 190 to come into contact with the upper surface of the first epitaxial pattern SD1.

The second source/drain contact 192 may be electrically connected to the second epitaxial pattern SD2. For example, the second source/drain contact 192 may penetrate the first interlayer insulating film 180 and the second interlayer insulating film 190 to come into contact with the upper surface of the second epitaxial pattern SD2.

The gate contact 196 may be electrically connected to the gate structure GS. For example, the gate contact 196 may penetrate the second interlayer insulating film 190 to come into contact with the upper surface of the gate electrode 130.

The front wiring structure FW may be formed on the second interlayer insulating film 190. The front wiring structure FW may include a front inter-wiring insulating film 210 and front wiring patterns 220. The front wiring pattern 220 may form a multi-layer wiring structure inside the front inter-wiring insulating film 210. The number of layers, the arrangement, and the like of the front inter-wiring insulating film 210 and the front wiring patterns 220 are merely an example, and are not limited to those shown in the drawings.

The front wiring structure FW may be electrically connected to the first epitaxial pattern SD1, the second epitaxial pattern SD2, and/or the gate structure GS. For example, the front wiring patterns 220 may be connected to the first source/drain contact 191, the second source/drain contact 192, and/or the gate contact 196.

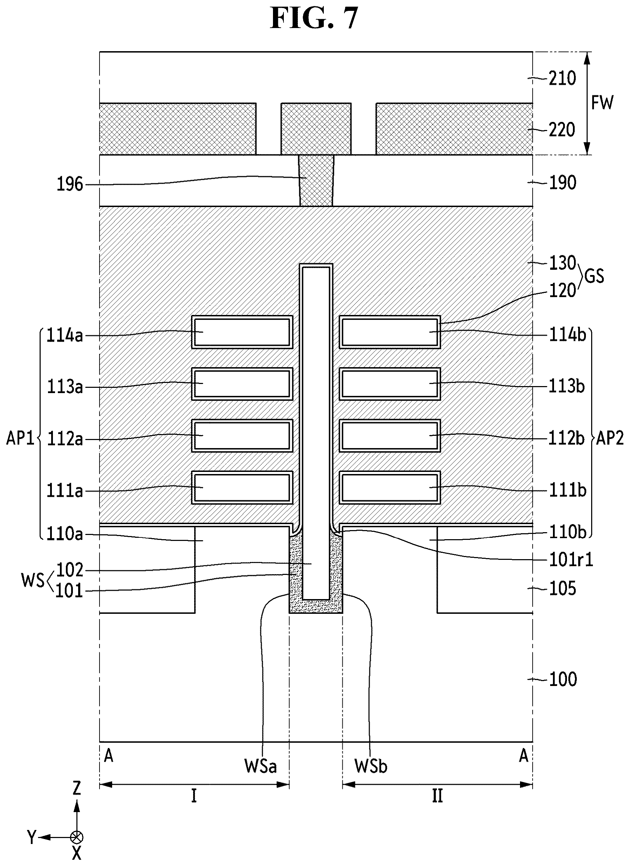

FIG. 7 is a cross-sectional view for explaining a semiconductor device according to some implementations. For reference, FIG. 7 is another cross-sectional view taken along A-A of FIG. 1. For convenience of explanation, repeated parts of contents explained above using FIGS. 1 to 6 will be briefly explained or omitted.

Referring to FIG. 7, in the semiconductor device according to some implementations, the liner film 101 is not interposed between the first active pattern AP1 and the wall pattern 102 and/or between the second active pattern AP2 and the wall pattern 102.

For example, in FIG. 7, the height of the uppermost portion of the liner film 101 may be lower than the height of the lowermost side of the first sheet pattern 111a and/or the height of the lowermost side of the fifth sheet pattern 111b. The upper surface of the liner film 101 interposed between the first fin pattern 110a and the wall pattern 102 and/or between the second fin pattern 110b and the wall pattern 102 may include a first recess 101r1 that is recessed downward.

In some implementations, the first recess 101r1 may include a concave side that is recessed downward (e.g., the concave side may at least partially face upward). In some implementations, the height of the first recess 101r1 may decrease as it goes away from the wall pattern 102. For example, as shown, the height of the side surface of the liner film 101 spaced apart from the wall pattern 102 may be lower than the height of the side surface of the liner film 101 adjacent to the wall pattern 102.

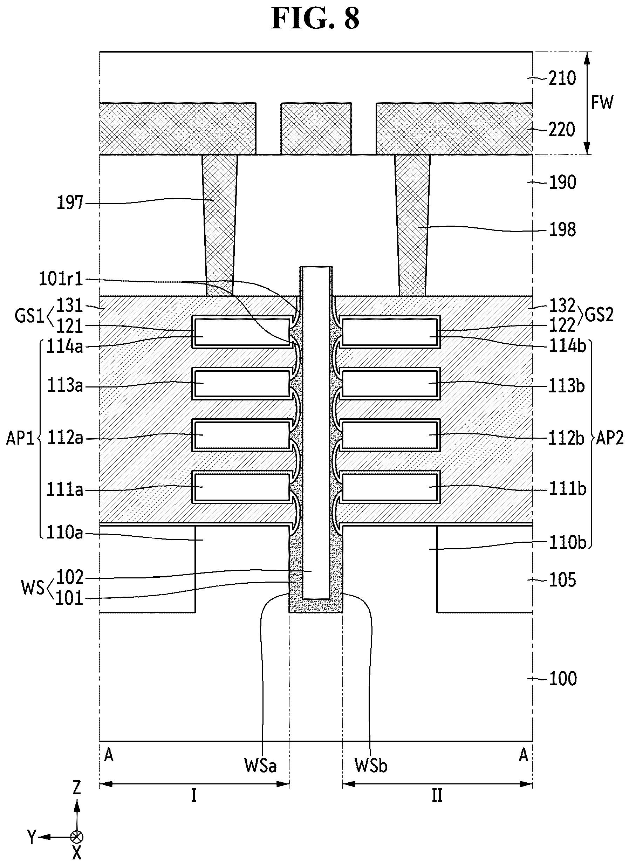

FIG. 8 is a cross-sectional view for explaining a semiconductor device according to some implementations. For reference, FIG. 8 is another cross-sectional view taken along A-A of FIG. 1. For convenience of explanation, repeated parts of contents explained above using FIGS. 1 to 7 will be briefly explained or omitted.

Referring to FIG. 8, a semiconductor device according to some implementations includes a first gate structure GS1, a second gate structure GS2, a first gate contact 197, and a second gate contact 198.

The first gate structure GS1 may intersect the first active pattern AP1. The second gate structure GS2 may intersect the second active pattern AP2. The wall structure WS may extend in the first direction X to separate the first gate structure GS1 and the second gate structure GS2. For example, the first gate structure GS1 may be formed on a first side surface WSa of the wall structure WS, and the second gate structure GS2 may be formed on a second side surface WSb of the wall structure WS. The wall structure WS may extend in the third direction Z across the full height of one or both of the first gate structure GS1 and the second gate structure GS2. For instance, the upper surface of the wall structure WS may be at a height that is greater than or equal to the height of one or both of the upper surface of the first gate structure GS1 and the upper surface of the second gate structure GS2.

The first gate structure GS1 may include a first gate dielectric film 121 and a first gate electrode 131. The second gate structure GS2 may include a second gate dielectric film 122 and a second gate electrode 132. Because each of the first gate dielectric film 121 and the second gate dielectric film 122 may be similar to the gate dielectric film 120 explained above using FIGS. 1 to 6, and each of the first gate electrode 131 and the second gate electrode 132 may be similar to the gate electrode 130 explained above using FIGS. 1 to 6, the detailed explanation will not be provided below.

The first gate contact 197 may be electrically connected to the first gate structure GS1. For example, the first gate contact 197 may penetrate the second interlayer insulating film 190 to come into contact with the upper surface of the first gate electrode 131.

The second gate contact 198 may be electrically connected to the second gate structure GS2. For example, the second gate contact 198 may penetrate the second interlayer insulating film 190 to come into contact with the upper surface of the second gate electrode 132.

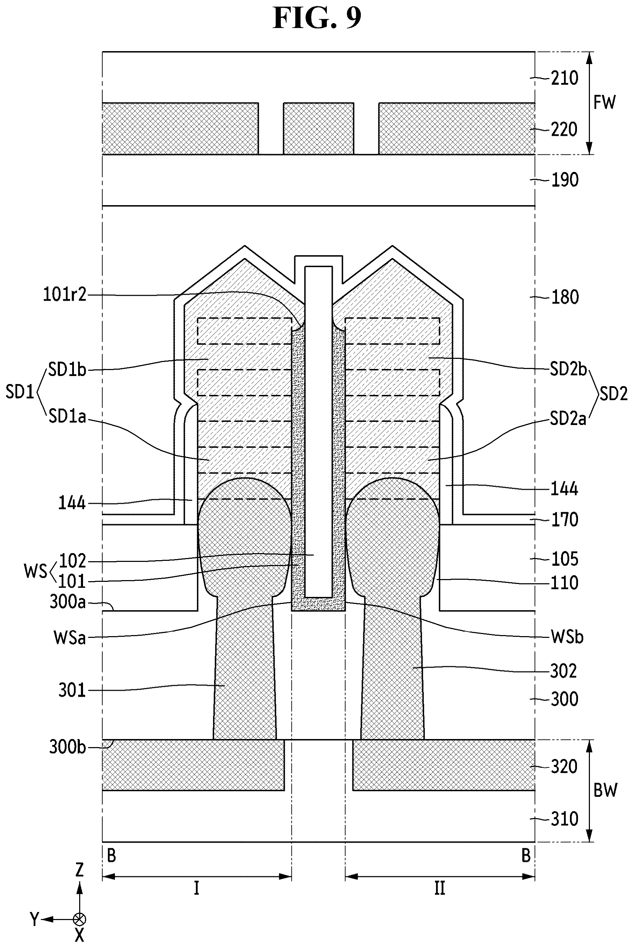

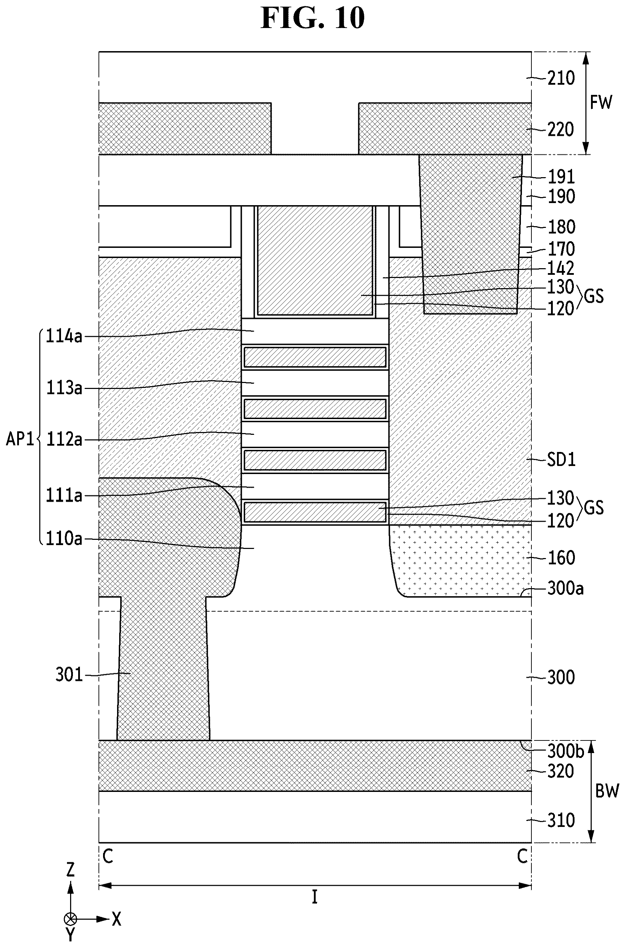

FIGS. 9 and 10 are cross-sectional views for explaining a semiconductor device according to some implementations. For reference, FIG. 9 is another cross-sectional view taken along B-B of FIG. 1, and FIG. 10 is another cross-sectional view taken along C-C of FIG. 1. For convenience of explanation, repeated parts of contents explained above using FIGS. 1 to 8 will be briefly explained or omitted.

Referring to FIGS. 9 and 10, the semiconductor device according to some implementations includes a second substrate 300, a holder pattern 160, a first back source/drain contact 301, a second back source/drain contact 302, and a back wiring structure BW.

The second substrate 300 may include a first side 300a and a second side 300b that are opposite to each other (e.g., in the third direction Z). The first active pattern AP1 and the second active pattern AP2 are formed on the first side 300a of the second substrate 300. In some implementations, the second substrate 300 may be an insulating substrate including an insulating material. For example, the second substrate 300 may include, but is not limited to, at least one of silicon oxide, silicon nitride, silicon oxynitride, silicon oxycarbide, silicon boron nitride, silicon boron carbonitride, silicon oxycarbonitride, a low dielectric constant (low-k) material having a lower dielectric constant than silicon oxide or a combination thereof. As an example, the second substrate 300 may include a silicon oxide film.

The holder pattern 160 may be formed under the first epitaxial pattern SD1 and/or the second epitaxial pattern SD2. For example, the holder pattern 160 may be formed inside the second substrate 300. In some implementations, unlike the shown example, the holder pattern 160 may be omitted.

The first back source/drain contact 301 may be formed under the first epitaxial pattern SD1. The first back source/drain contact 301 may be electrically connected to the first epitaxial pattern SD1. For example, the first back source/drain contact 301 may penetrate the second substrate 300 and the holder pattern 160 to come into contact with the lower surface of the first epitaxial pattern SD1.

The second back source/drain contact 302 may be formed under the second epitaxial pattern SD2. The second back source/drain contact 302 may be electrically connected to the second epitaxial pattern SD2. For example, the second back source/drain contact 302 may penetrate the second substrate 300 and the holder pattern 160 to come into contact with the lower surface of the second epitaxial pattern SD2.

The back wiring structure BW may be formed on the second side 300b of the second substrate 300. The back wiring structure BW may include a back inter-wiring insulating film 310 and back wiring patterns 320. The back wiring patterns 320 may form a wiring structure of multi-layer inside the back inter-wiring insulating film 310. The number of layers, number, arrangement and the like of the back inter-wiring insulating film 310 and the back wiring patterns 320 are merely an example and are not limited to those shown in the drawings.

The back wiring structure BW may be electrically connected to the first epitaxial pattern SD1 and/or the second epitaxial pattern SD2. For example, the back wiring patterns 320 may be connected to the first back source/drain contact 301 and/or the second back source/drain contact 302.

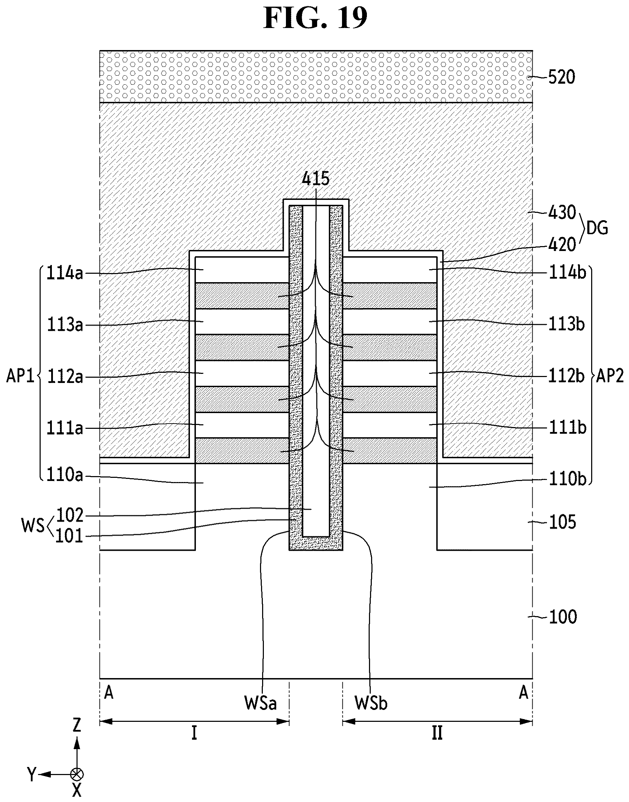

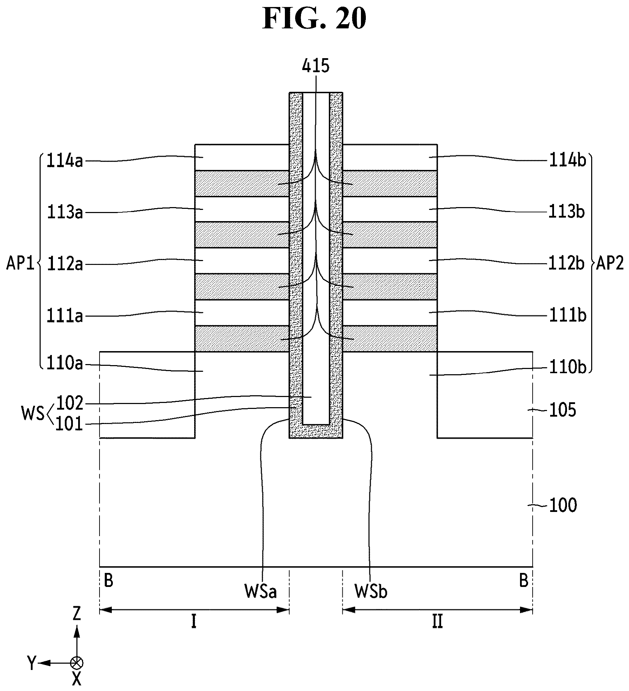

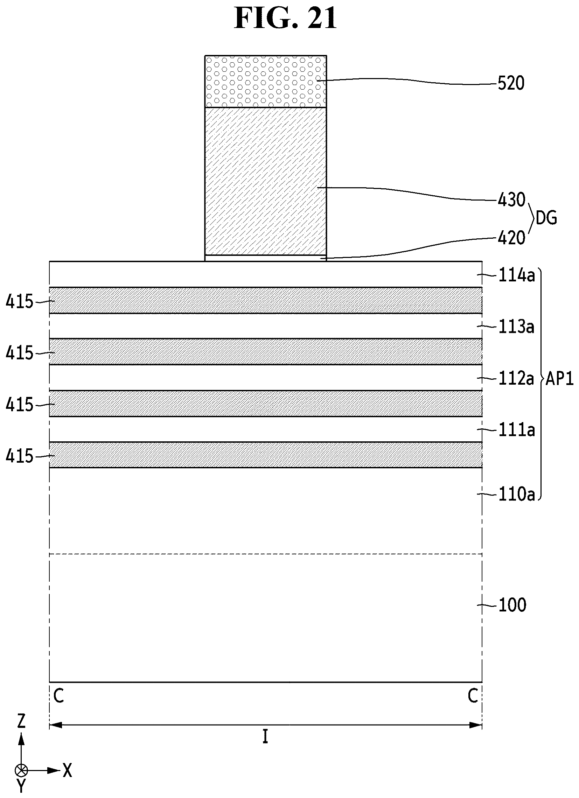

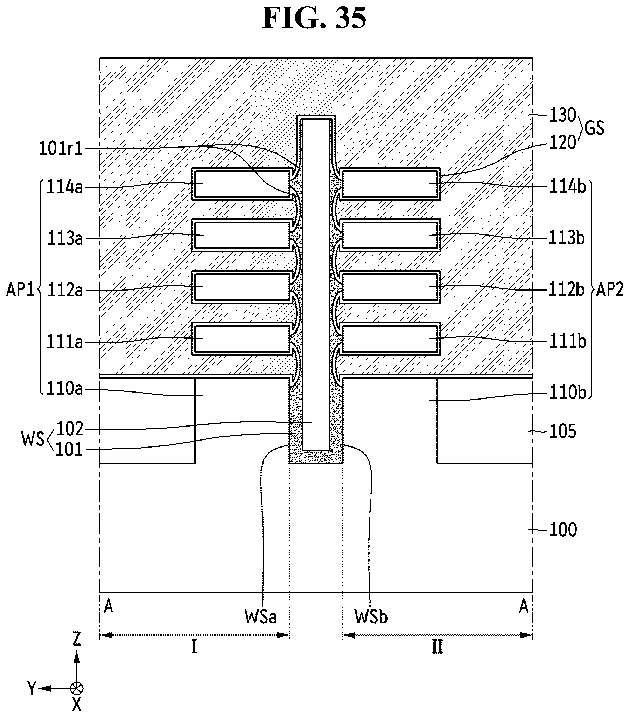

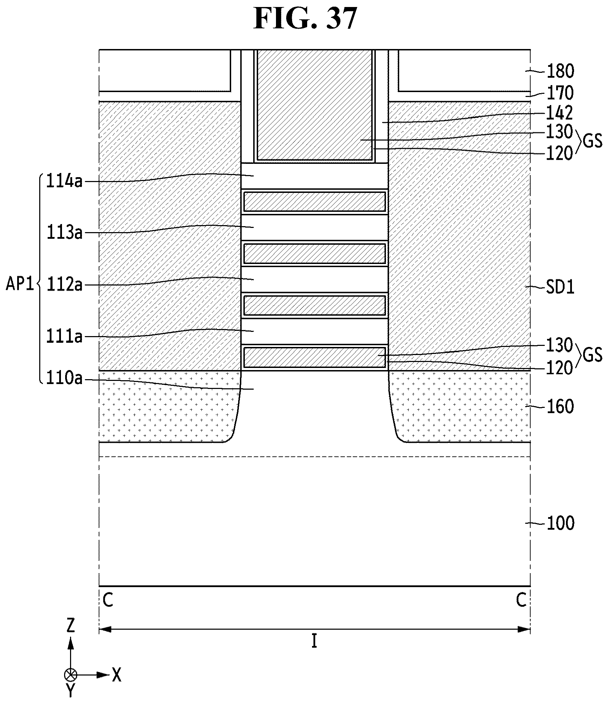

Hereinafter, a method for fabricating a semiconductor device according to some implementations will be explained referring to FIGS. 1 to 43.

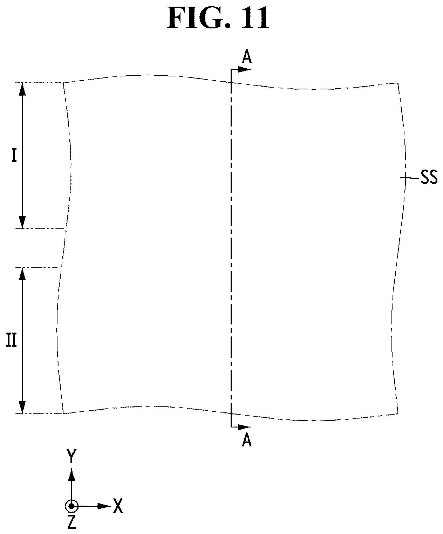

FIGS. 11 to 37 are intermediate step diagrams for explaining the method for fabricating the semiconductor device according to some implementations. For convenience of description, repeated parts of contents explained above using FIGS. 1 to 10 will be briefly explained or omitted.

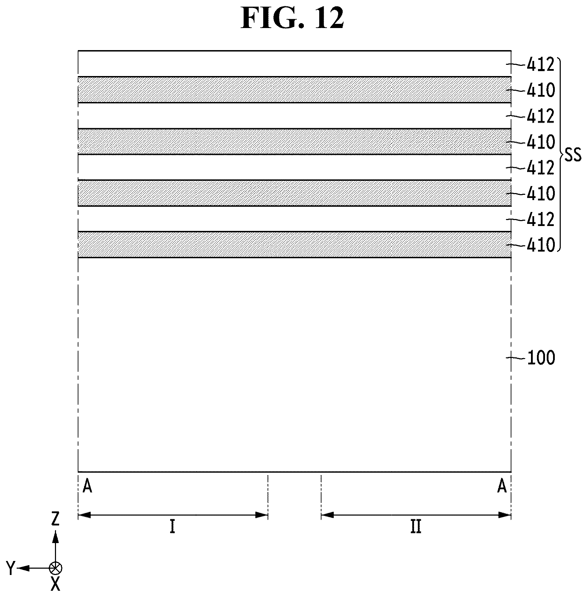

Referring to FIGS. 11 and 12, a stacked structure SS is formed on the first substrate 100.

The stacked structure SS may include a plurality of sacrificial films 410 and a plurality of active films 412. The sacrificial films 410 and the active films 412 may be alternately stacked along the third direction Z. The active films 412 may be spaced apart from each other by the sacrificial films 410. The sacrificial films 410 may have an etch selectivity with respect to the active films 412. As an example, each of the active films 412 may include a silicon (Si) film, and each of the sacrificial films 410 may include a silicon germanium (SiGe) film.

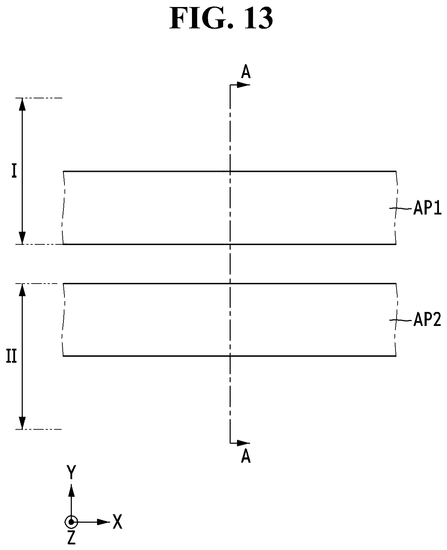

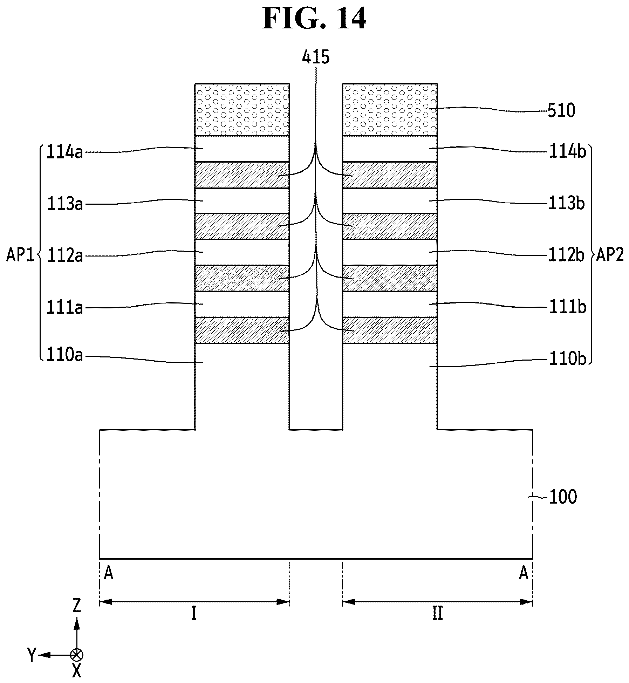

Referring to FIGS. 13 and 14, the first active pattern AP1 and the second active pattern AP2 are formed on the first substrate 100.

For example, a first mask pattern 510 may be formed on the stacked structure SS of FIGS. 11 and 12. Next, a patterning process for patterning the stacked structure SS using the first mask pattern 510 as an etching mask may be performed. As the patterning process is performed, the sacrificial pattern 415 may be formed from the sacrificial films 410, the first active pattern AP1 may be formed from the active films 412 on the first region I, and the second active pattern AP2 may be formed from the active films 412 on the second region II.

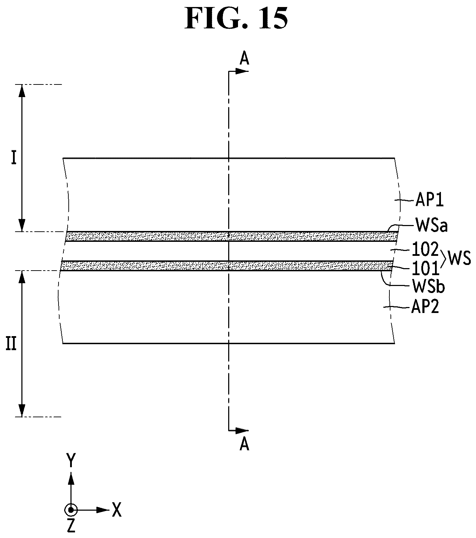

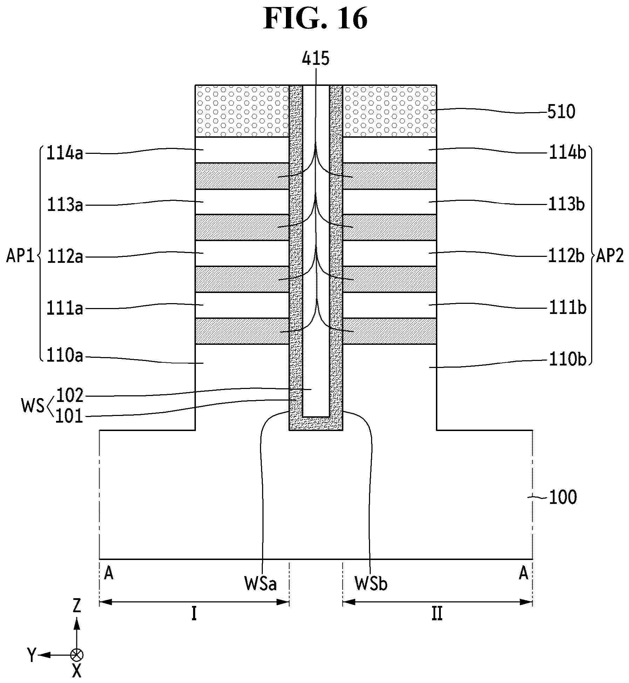

Referring to FIGS. 15 and 16, the wall structure WS is formed on the first substrate 100.

The wall structure WS may be formed between the first region I and the second region II. The wall structure WS may fill at least a part of the region between the first active pattern AP1 and the second active pattern AP2. As a result, the wall structure WS may separate the first active pattern AP1 and the second active pattern AP2.

The wall structure WS may include a liner film 101 and a wall pattern 102 that are stacked in order. For example, the liner film 101 may conformally extend along the profiles of the upper surface of the first substrate 100, the side surface of the sacrificial pattern 415, the side surface of the first active pattern AP1, and the side surface of the second active pattern AP2. The wall pattern 102 may be formed to fill at least a part of the region on the liner film 101.

The liner film 101 and the wall pattern 102 may include different insulating materials from each other. The liner film 101 may have an etch selectivity with respect to the wall pattern 102. As an example, the liner film 101 may include a silicon nitride film, and the wall pattern 102 may include at least one of a silicon oxynitride film, a silicon oxycarbide film or a low dielectric constant (low-k) material film.

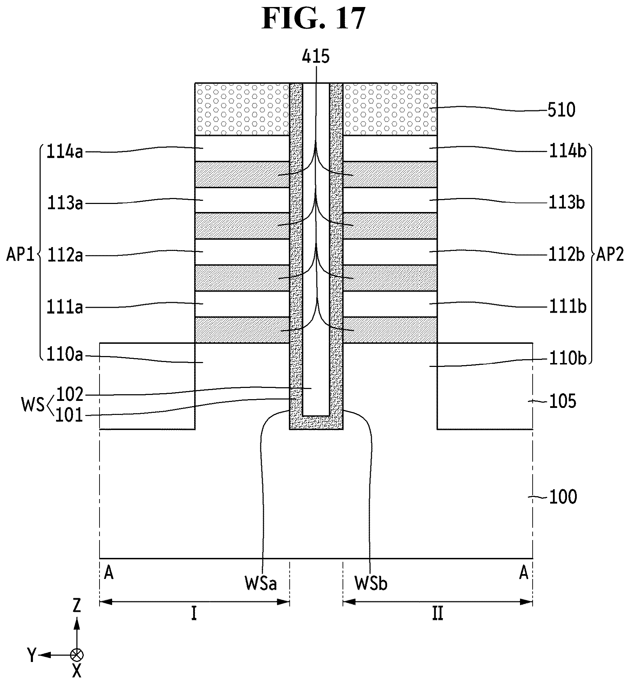

Referring to FIG. 17, the field insulating film 105 is formed on the first substrate 100.

The field insulating film 105 may be formed after the wall structure WS is formed. The field insulating film 105 may cover at least a part of the side surface of the first fin pattern 110a and at least a part of the side surface of the second fin pattern 110b.

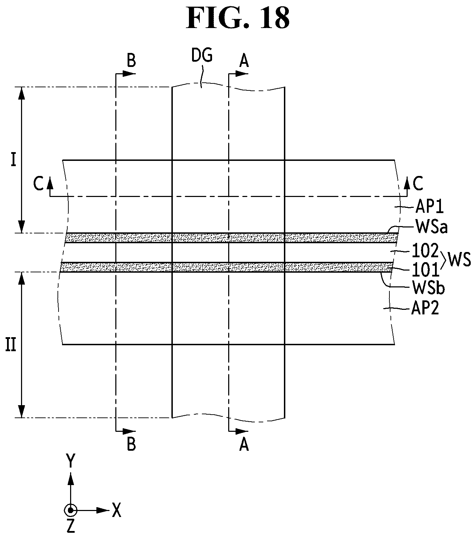

Referring to FIGS. 18 to 21, a dummy gate DG is formed.

The dummy gate DG may be formed on the first active pattern AP1 and the second active pattern AP2. The dummy gate DG may intersect the first active pattern AP1 and the second active pattern AP2. For example, the dummy gate DG may extend (e.g., may extend long) in the second direction Y. The dummy gate DG may cover a part of the first active pattern AP1, a part of the second active pattern AP2, and a part of the wall structure WS, and may expose the other part of the first active pattern AP1, the other part of the second active pattern AP2, and the other part(s) of the wall structure WS.

In some implementations, the dummy gate DG may include a dummy insulating film 420 and a dummy electrode 430 that are sequentially stacked on the first active pattern AP1 and the second active pattern AP2. For example, an insulating film and an electrode film may be sequentially formed on the first active pattern AP1 and the second active pattern AP2. Next, a second mask pattern 520 extending in the second direction Y may be formed on the electrode film. Next, a patterning process for patterning the insulating film and the electrode film using the second mask pattern 520 may be performed.

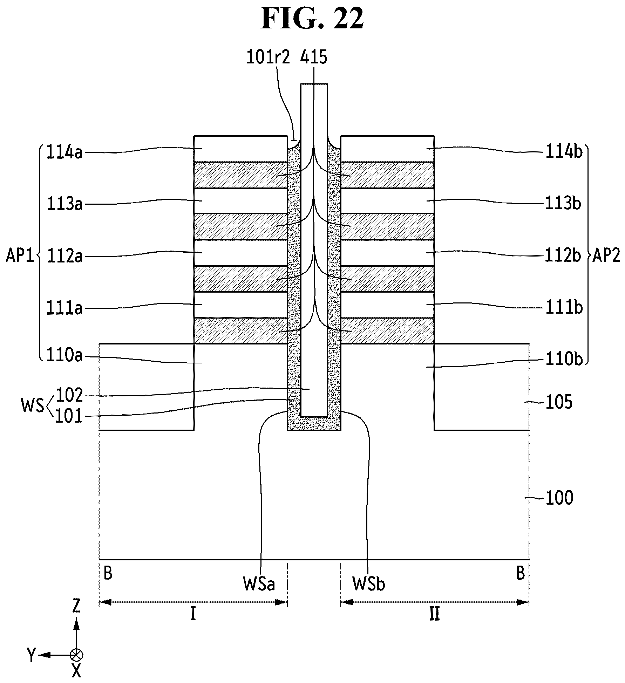

Referring to FIG. 22, a recess process is performed on the liner film 101 exposed from the dummy gate DG.

In the recess process, the liner film 101 may be selectively removed with respect to the wall pattern 102. As the recess process is performed, the height of the uppermost portion of the liner film 101 may be formed to be lower than the height of the uppermost portion of the wall pattern 102 in FIG. 22. For example, the height of the uppermost portion of the second recess 101r2 may be lower than the height of the uppermost portion of the wall pattern 102.

Referring to FIGS. 23 to 25, a spacer film 140 is formed.

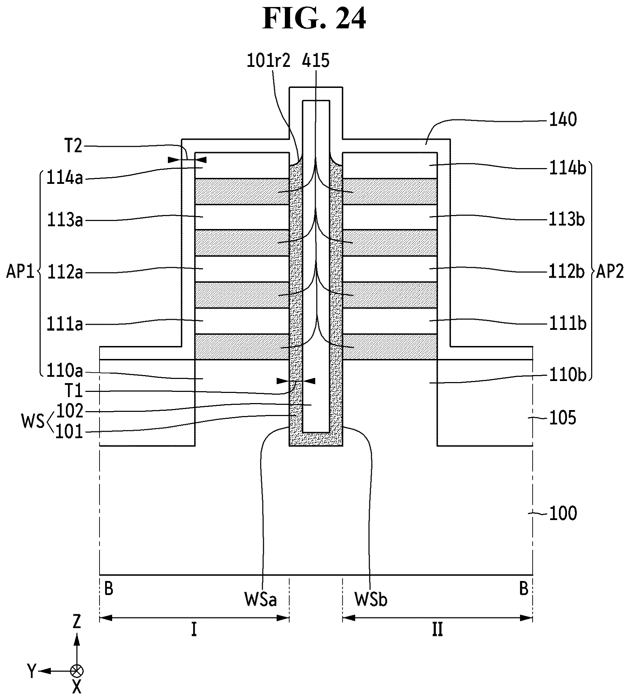

The spacer film 140 may extend conformally along the surfaces of the field insulating film 105, the wall structure WS, the sacrificial pattern 415, the first active pattern AP1, the second active pattern AP2, and the dummy gate DG. Also, as shown in FIG. 24, the spacer film 140 may be formed on the second recess 101r2.

In some implementations, the thickness T2 of the spacer film 140 may be equal to or less than the thickness T1 of the liner film 101 in the second direction Y. In this case, the portion of the spacer film 140 extending along the side surface of the wall structure WS may not overlap the first active pattern AP1 and/or the second active pattern AP2 in the third direction Z.

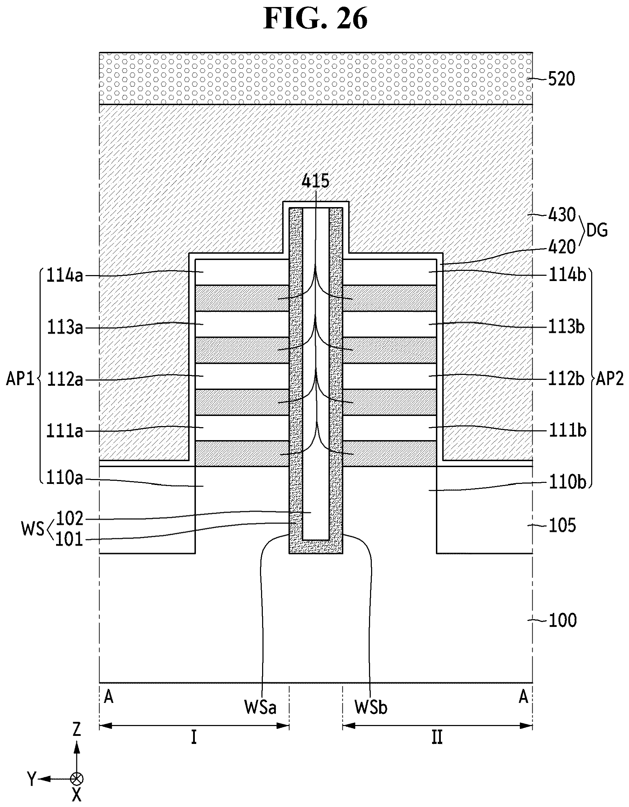

Referring to FIGS. 26 to 28, a first source/drain recess AP1r and a second source/drain recess AP2r are formed.

For example, a recess process for the sacrificial pattern 415, the first active pattern AP1, and the second active pattern AP2 may be performed on the spacer film 140 of FIGS. 23 to 25. As the recess process is performed, the first source/drain recess AP1r may be formed in the sacrificial pattern 415 and the first active pattern AP1, and the second source/drain recess AP2r may be formed in the sacrificial pattern 415 and the second active pattern AP2. The recess process may remove one or more portions of the sacrificial pattern 415, the first active pattern AP1, and the second active pattern AP2 not covered by the dummy gate DG or the spacer film 140. For instance, the dummy gate DG and the spacer film 140 may be used as a mask for the recess process.

In the process of performing the recess process, the spacer film 140 on the side surface of the dummy gate DG may be recessed to form a gate spacer 142. Further, in the process of performing the recess process, the spacer film 140 on the side surface of the sacrificial pattern 415, the side surface of the first active pattern AP1, and the side surface of the second active pattern AP2 may be recessed to form a spacer pattern 144. The recess process may be an anisotropic etching process (e.g., that has a higher etching rate in the third direction Z than in one or both of the first direction X and the second direction Y).

As explained above using FIGS. 23 to 25, the portion of the spacer film 140 extending along the side surface of the wall structure WS may not overlap the first active pattern AP1 and/or the second active pattern AP2 in the third direction Z. This makes it possible to effectively prevent a so-called shadowing effect caused by a part of the first active pattern AP1 and/or a part of the second active pattern AP2 being blocked and remaining in the process of forming the first source/drain recess AP1r and the second source/drain recess AP2r, due to the portion of the spacer film 140 extending along the side surface of the wall structure WS.

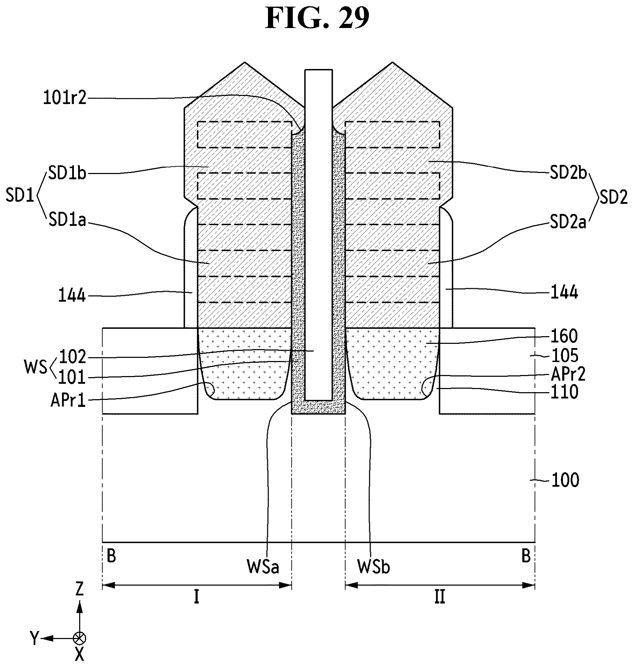

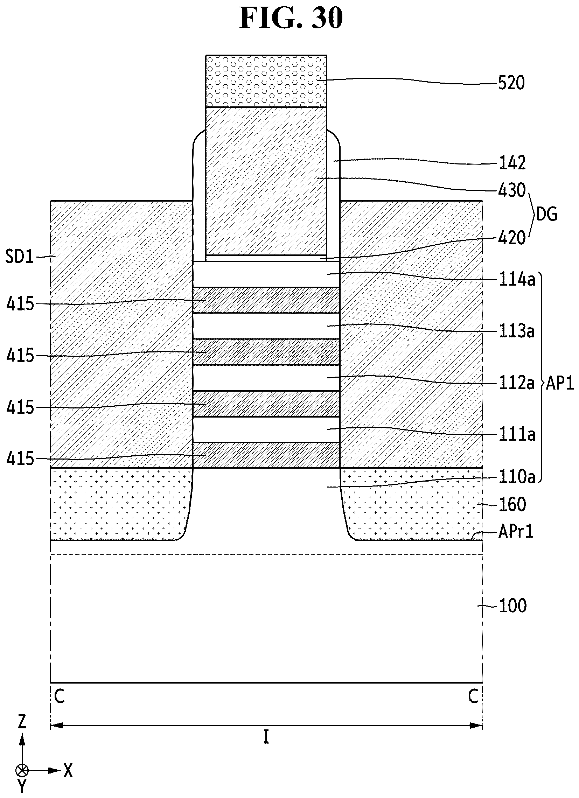

Referring to FIGS. 29 and 30, the first epitaxial pattern SD1 and the second epitaxial pattern SD2 are formed.

The first epitaxial pattern SD1 may be formed inside the first source/drain recess AP1r. For example, an epitaxial growth process using the first substrate 100 and/or the first active pattern AP1 as a seed layer may be performed. Accordingly, the first epitaxial pattern SD1 connected to the first active pattern AP1 in the first direction X may be formed.

The second epitaxial pattern SD2 may be formed inside the second source/drain recess AP2r. For example, an epitaxial growth process using the first substrate 100 and/or the second active pattern AP2 as a seed layer may be performed. Accordingly, the second epitaxial pattern SD2 connected to the second active pattern AP2 in the first direction X may be formed.

In some implementations, before the first epitaxial pattern SD1 and the second epitaxial pattern SD2 are formed, the holder pattern 160 may be formed inside the first source/drain recess AP1r and/or the second source/drain recess AP2r. The first epitaxial pattern SD1 and/or the second epitaxial pattern SD2 may be formed on the holder pattern 160.

The holder pattern 160 may be formed inside the first fin pattern 110a and/or the second fin pattern 110b. The holder pattern 160 may be formed by an epitaxial growth process using the first substrate 100, the first fin pattern 110a, and/or the second fin pattern 110b as a seed layer.

The holder pattern 160 may include a material having an etch selectivity with respect to the first substrate 100, the first fin pattern 110a, and/or the second fin pattern 110b. As an example, the first substrate 100 may be a silicon substrate, each of the first fin pattern 110a and the second fin pattern 110b may be a silicon pattern, and the holder pattern 160 may be a silicon germanium pattern.

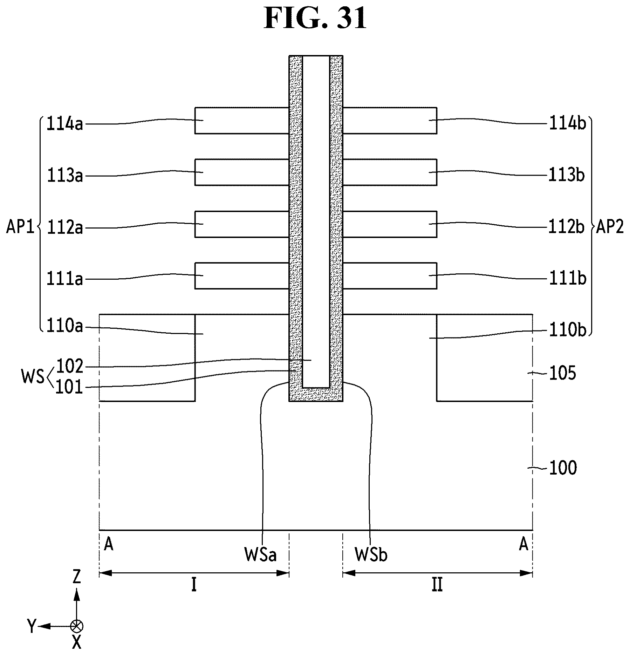

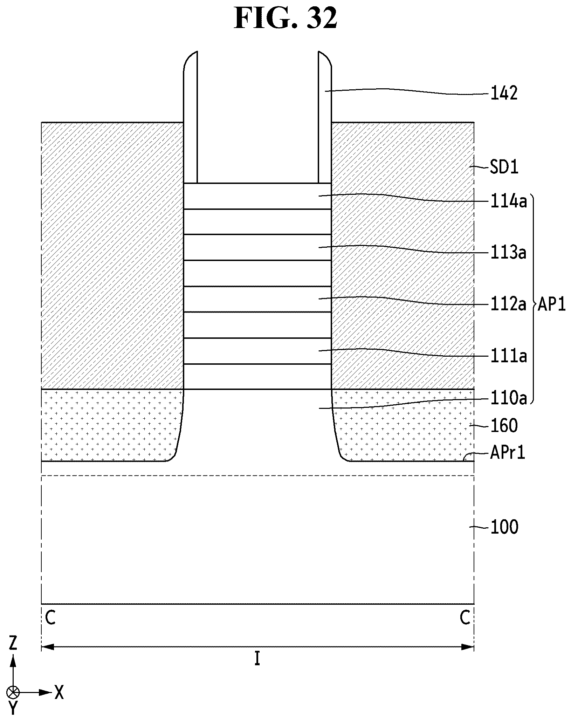

Referring to FIGS. 31 and 32, the dummy gate DG and the sacrificial pattern 415 are removed.

The dummy gate DG and the sacrificial pattern 415 may be selectively removed with respect to the first active pattern AP1 and the second active pattern AP2. As the dummy gate DG and the sacrificial pattern 415 are removed, the first active pattern AP1 and the second active pattern AP2 disposed inside the gate spacer 142 may be exposed.

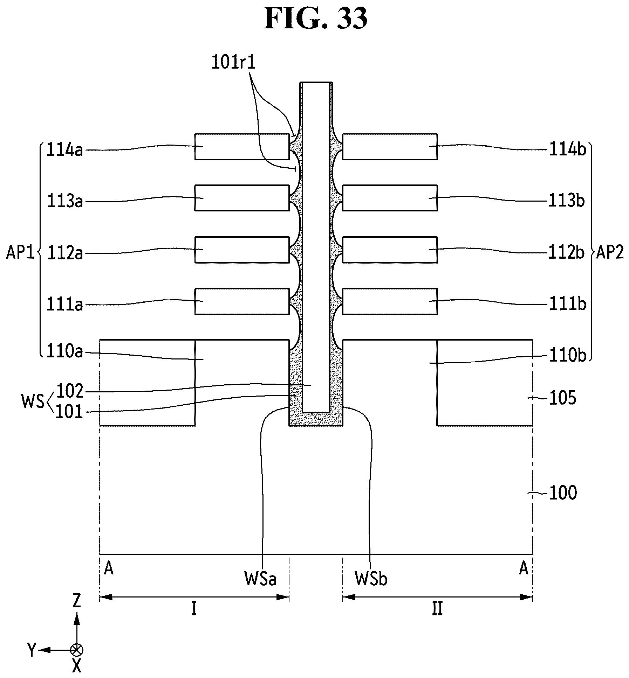

Referring to FIG. 33, a recess process is performed on the liner film 101 exposed inside the gate spacer 142. The recess process may be an etching process. The recess process may recess (e.g., etch) the portions of the liner film 101 exposed between the first fin pattern 110a and the lowermost first bridge pattern 111a, between the first bridge patterns 111a to 114a, above the uppermost first bridge pattern 114a, between the second fin pattern 110b and the lowermost second bridge pattern 111b, between the second bridge patterns 111b to 114b and above the uppermost second bridge patterns 114b.

As the recess process is performed, the first recess 101r1 recessed toward the wall pattern 102 may be formed inside the liner film 101 interposed between the first active pattern AP1 and the wall pattern 102 and between the second active pattern AP2 and the wall pattern 102.

In some implementations, the first recess 101r1 opposite to the first active pattern AP1 may include a concave side recessed toward the first active pattern AP1 (e.g., toward the left side in FIG. 33), and the first recess 101r1 opposite to the second active pattern AP2 may include a concave side recessed toward the second active pattern AP2 (toward the right side in FIG. 33).

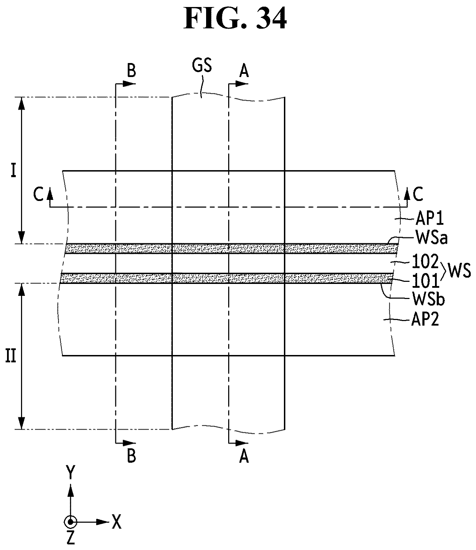

Referring to FIGS. 34 to 37, the gate structure GS is formed.

For example, the gate dielectric film 120 and the gate electrode 130 may be sequentially stacked on the first active pattern AP1 and the second active pattern AP2 exposed inside the gate spacer 142. Accordingly, the gate structure GS that surrounds peripheries of each of the first bridge patterns 111a to 114a and peripheries of each of the second bridge patterns 111b to 114b may be formed.

After the gate structure GS is formed, the etch stop layer 170 and the first interlayer insulating film 180 may be formed.

Next, referring to FIGS. 1 to 6, the second interlayer insulating film 190, the first source/drain contact 191, the second source/drain contact 192, the gate contact 196, and the front wiring structure FW are formed. Accordingly, the semiconductor device explained above referring to FIGS. 1 to 6 may be fabricated.

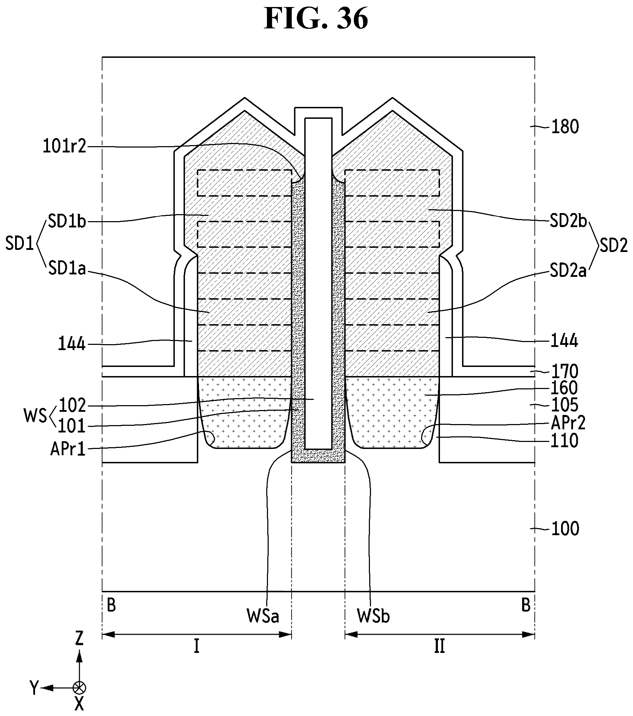

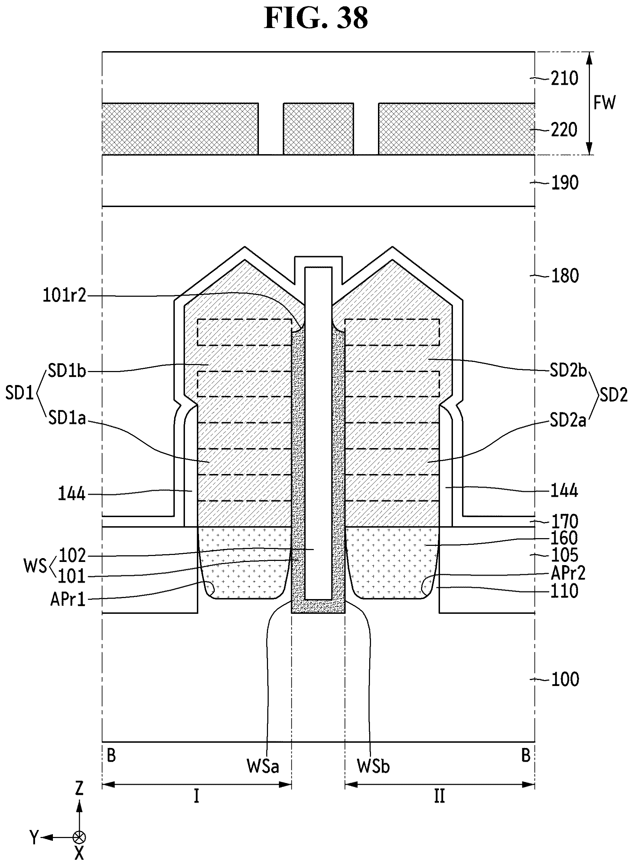

FIGS. 38 to 43 are intermediate step diagrams for explaining the method for fabricating the semiconductor device according to some implementations. For convenience of explanation, repeated parts of contents explained above using FIGS. 1 to 37 will be briefly explained or omitted. For reference, FIG. 38 is an intermediate step diagram for explaining steps after FIG. 36.

Referring to FIG. 38, the second interlayer insulating film 190 and the front wiring structure FW are formed.

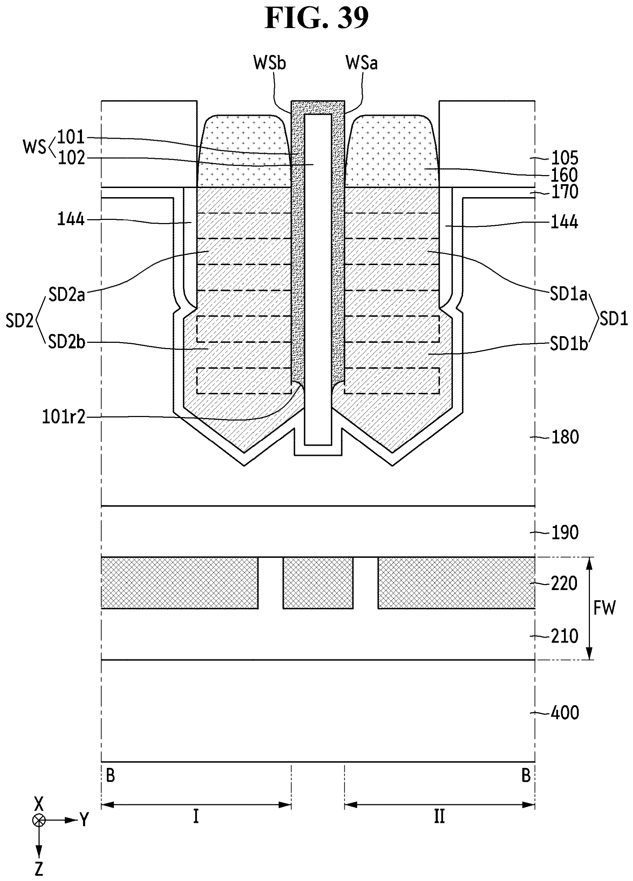

Referring to FIG. 39, a thinning process is performed on the first substrate 100.

For example, a carrier substrate 400 may be attached onto the product of FIG. 38. After the carrier substrate 400 is attached, the product of FIG. 38 may be inverted. Accordingly, the back side of the first substrate 100 may face upward. Next, the thinning process (e.g., a back grinding process) may be performed on the back side of the first substrate 100. As the thinning process is performed, at least a part of the first substrate 100 may be removed. In some implementations, the entirety of the first substrate 100 is removed.

In some implementations, the field insulating film 105 and the wall structure WS may be exposed by the thinning process. In some implementations, the holder pattern 160 may be exposed by the thinning process.

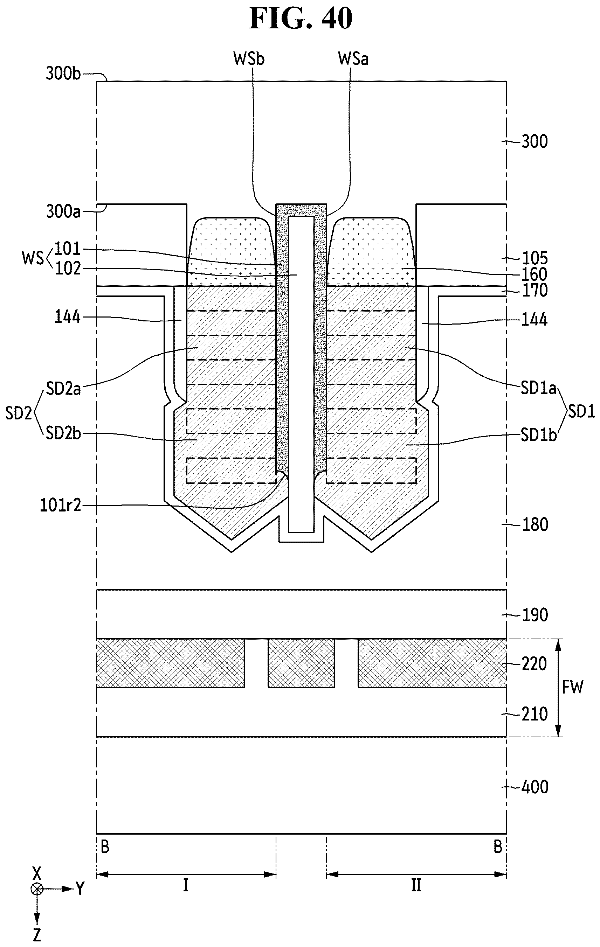

Referring to FIG. 40, the second substrate 300 is formed on the field insulating film 105, the wall structure WS, and the holder pattern 160.

The second substrate 300 may include a first side 300a and a second side 300b that are opposite to each other. The field insulating film 105, the wall structure WS, and the holder pattern 160 may be disposed on the first side 300a of the second substrate 300. In some implementations, the second substrate 300 may be an insulating substrate including an insulating material.

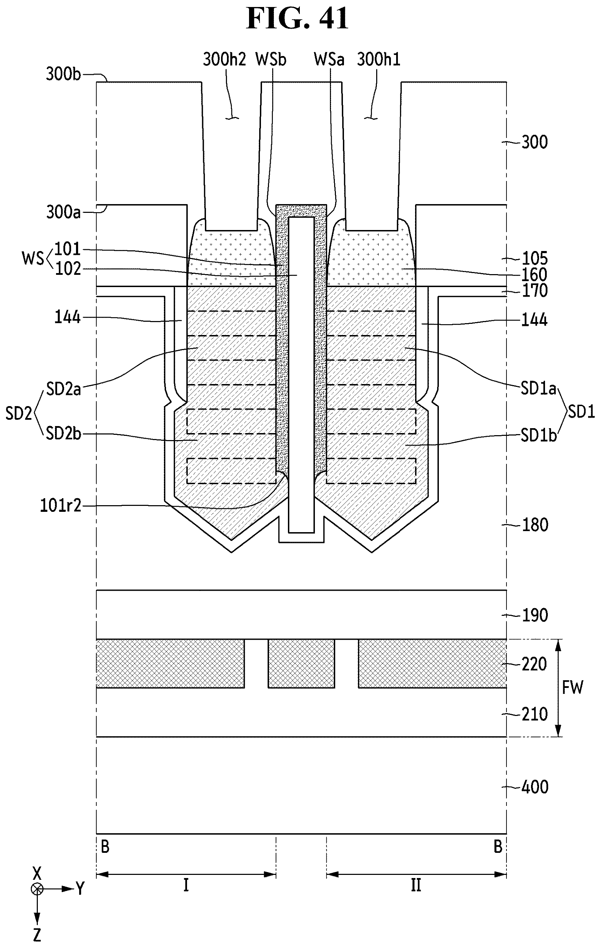

Referring to FIG. 41, a first contact hole 300h1 and a second contact hole 300h2 are formed inside the second substrate 300.

Each of the first contact hole 300h1 and the second contact hole 300h2 may extend in the third direction Z and penetrate the second substrate 300. The first contact hole 300h1 may expose the holder pattern 160 connected to the first epitaxial pattern SD1. The second contact hole 300h2 may expose the holder pattern 160 connected to the second epitaxial pattern SD2.

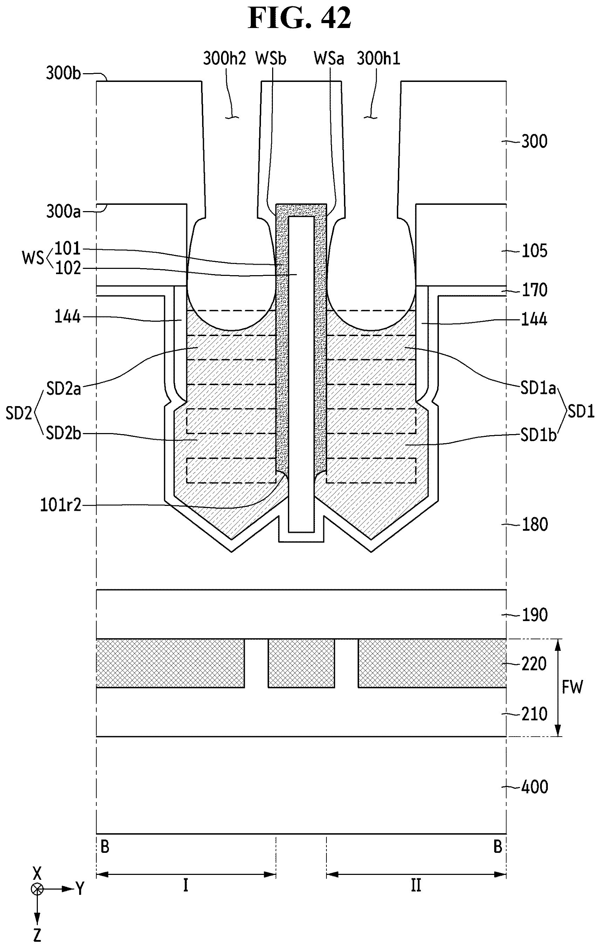

Referring to FIG. 42, the holder pattern 160 is removed.

For example, an etching process for removing the holder pattern 160 using the first contact hole 300h1 and the second contact hole 300h2 may be performed. In the etching process, the holder pattern 160 may be selectively removed from the second substrate 300. As the etching process is performed, the first epitaxial pattern SD1 may be exposed by the first contact hole 300h1, and the second epitaxial pattern SD2 may be exposed by the second contact hole 300h2.

In some implementations, a part of the first epitaxial pattern SD1 and/or a part of the second epitaxial pattern SD2 may be removed in the etching process.

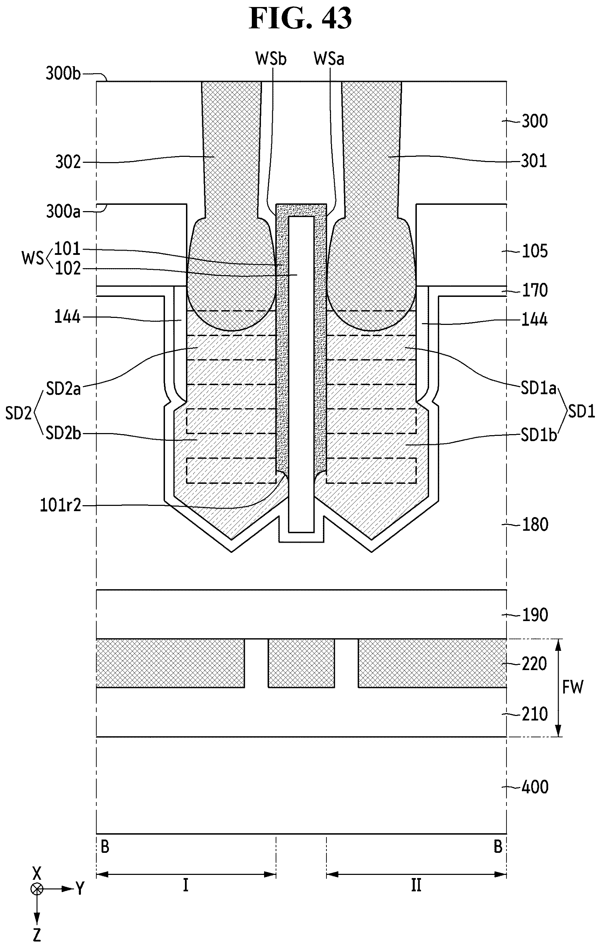

Referring to FIG. 43, a first back source/drain contact 301 and a second back source/drain contact 302 are formed.

The first back source/drain contact 301 may penetrate the second substrate 300, and be connected to the first epitaxial pattern SD1. For example, the first back source/drain contact 301 may fill the first contact hole 300h1 of FIG. 42.

The second back source/drain contact 302 may penetrate the second substrate 300, and be connected to the second epitaxial pattern SD2. For example, the second back source/drain contact 302 may fill the second contact hole 300h2 of FIG. 42.

Next, referring to FIG. 9, the back wiring structure BW is formed on the second side 300b of the second substrate 300. The carrier substrate 400 may be removed. Accordingly, the semiconductor device explained above using FIGS. 9 and 10 may be fabricated.

Embodiments are set out in the following Clauses:
Clause 1. A semiconductor device comprising:
   a substrate comprising a first region and a second region;
   a first bridge pattern on the first region, wherein the first bridge pattern is spaced apart from the substrate and extends in a first direction;
   a second bridge pattern on the second region, wherein the second bridge pattern is spaced apart from the substrate and extends in the first direction;
   a gate electrode, which extends in a second direction that intersects the first direction, wherein the first bridge pattern and the second bridge pattern extend into the gate electrode;
   a gate spacer which extends along a side surface of the gate electrode, wherein the first bridge pattern and the second bridge pattern extend into the gate spacer;
   a first epitaxial pattern on a side surface of the gate spacer, wherein the first epitaxial pattern is connected to the first bridge pattern in the first direction;
   a second epitaxial pattern on the side surface of the gate spacer, wherein the second epitaxial pattern is connected to the second bridge pattern in the first direction; and
   a wall structure between the first region and the second region, wherein the wall structure separates the first bridge pattern from the second bridge pattern, and separates the first epitaxial pattern from the second epitaxial pattern,
   wherein the wall structure comprises a wall pattern that extends in the first direction and comprises a first insulating material, and a liner film that extends along a lower surface and a side surface of the wall pattern and comprises a second insulating material different from the first insulating material, and
   a thickness of the liner film interposed between the first epitaxial pattern and the wall pattern is equal to or greater than a thickness of the gate spacer.
Clause 2. The semiconductor device of Clause 1,
   wherein an upper surface of the substrate comprises a (110) crystal plane.
Clause 3. The semiconductor device of Clause 1 or Clause 2,
   wherein an upper surface of the liner film interposed between the first epitaxial pattern and the wall pattern comprises a recess, and
   a height of an uppermost portion of the recess is lower than a height of an uppermost portion of the first bridge pattern.
Clause 4. The semiconductor device of any of Clause 1-3,
   wherein the first epitaxial pattern comprises an outer side surface that extends in a direction that intersects the second direction and is spaced apart from the wall structure, and
   a distance between the outer side surface and the first bridge pattern in the second direction is equal to or less than the thickness of the liner film in the second direction.
Clause 5. The semiconductor device of any preceding Clause, comprising:
   a spacer pattern on the substrate,
   wherein the first epitaxial pattern is interposed between the wall structure and the spacer pattern in the second direction, and
   the thickness of the liner film interposed between the first epitaxial pattern and the wall pattern is equal to or greater than a thickness of the spacer pattern.
Clause 6. The semiconductor device of any preceding Clause,
   wherein the thickness of the liner film is 5 nm to 10 nm.
Clause 7. The semiconductor device of any preceding Clause,
   wherein a thickness of the wall structure in the second direction is 20 nm to 25 nm.
Clause 8. The semiconductor device of any preceding Clause, comprising:
   a back source/drain contact which extends into the substrate and is connected to a lower surface of the first epitaxial pattern.
Clause 9. A semiconductor device comprising:
   a substrate comprising a first side and a second side opposite to the first side;
   a wall structure which extends in a first direction on the first side, wherein the wall structure comprises a first side surface and a second side surface opposite the first side surface in a second direction that intersects the first direction;
   a first bridge pattern on the first side surface and spaced apart from the substrate, wherein the first bridge pattern extends in the first direction, and wherein an upper surface of the first bridge pattern comprises a (110) crystal plane;
   a second bridge pattern on the second side surface and spaced apart from the substrate, wherein the second bridge pattern extends in the first direction, and wherein an upper surface of the second bridge pattern comprises a (110) crystal plane;
   a gate electrode which extends in the second direction, wherein the first bridge pattern and the second bridge pattern extend into the gate electrode;
   a gate spacer which extends along a side surface of the gate electrode, wherein the first bridge pattern and the second bridge pattern extend into the gate spacer;
   a first epitaxial pattern on a side surface of the gate spacer, wherein the first epitaxial pattern is connected to the first bridge pattern in the first direction;
   a second epitaxial pattern on the side surface of the gate spacer, wherein the second epitaxial pattern is connected to the second bridge pattern in the first direction;
   a back wiring structure on the second side; and
   a back source/drain contact which extends into the substrate, wherein the back source/drain contact connects the first epitaxial pattern and the back wiring structure,
   wherein the wall structure comprises a wall pattern that extends in the first direction and comprises a first insulating material, and a liner film that extends along a lower surface and a side surface of the wall pattern and comprises a second insulating material different from the first insulating material,
   a height of an uppermost portion of the liner film interposed between the first epitaxial pattern and the wall pattern is lower than a height of an uppermost portion of the first bridge pattern,
   a thickness of the liner film interposed between the first epitaxial pattern and the wall pattern is equal to or greater than a thickness of the gate spacer, and
   a part of the gate electrode is interposed between the first bridge pattern and the second bridge pattern in the second direction.
Clause 10. The semiconductor device of Clause 9,
   wherein the substrate comprises an insulating material.

While the present disclosure has been particularly shown and described with reference to example implementations thereof, it will be understood by those of ordinary skill in the art that various changes in form and details may be made therein without departing from the scope of the present disclosure as defined by the following claims. It is therefore desired that the present implementations be considered in all respects as illustrative and not restrictive, reference being made to the appended claims rather than the foregoing description to indicate the scope of the invention.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a substrate (100);
a wall structure (WS) which extends in a first direction on the substrate (100), wherein the wall structure (WS) comprises a first side surface (WSa) and a second side surface (WSb) opposite to the first side surface along a second direction that intersects the first direction;
a first active pattern (AP1) on the first side surface (WSa), wherein the first active pattern (AP1) extends in the first direction;
a second active pattern (AP2) on the second side surface (WSb), wherein the second active pattern (AP2) extends in the first direction;
a gate structure (GS) on the first active pattern (AP1) and the second active pattern (AP2), wherein the gate structure (GS) extends in the second direction;
a first epitaxial pattern (SD1) on a side surface of the gate structure (GS), wherein the first epitaxial pattern (SD1) is connected to the first active pattern (AP1) in the first direction; and
a second epitaxial pattern (SD2) on the side surface of the gate structure (GS), wherein the second epitaxial pattern (SD2) is connected to the second active pattern (AP2) in the first direction,
wherein the wall structure (WS) comprises a wall pattern (102) that extends in the first direction and comprises a first insulating material, and a liner film (101) that extends along a lower surface and a side surface of the wall pattern (102) and comprises a second insulating material different from the first insulating material, and
the liner film (101) is interposed between the first epitaxial pattern (SD1) and the wall pattern (102) and between the second epitaxial pattern (SD2) and the wall pattern (102).

2. The semiconductor device of claim 1,
wherein an upper surface of each of the first active pattern (AP1) and the second active pattern (AP2) comprises a (110) crystal plane.

3. The semiconductor device of claim 1 or claim 2,
wherein the first active pattern (AP1) comprises a first bridge pattern (111a) and a second bridge pattern (112a) spaced apart from the first bridge pattern (111a) in a third direction that intersects the first direction and the second direction,
the liner film (101) comprises a first recess (101r1) that extends toward the wall pattern (102),
the first recess (101r1) overlaps the first bridge pattern (111a) and the second bridge pattern (112a) in the second direction, and
the gate structure (GS) at least partially fills the first recess (101r1).

4. The semiconductor device of any preceding claim,
wherein an upper surface of the liner film (101) interposed between the first epitaxial pattern (SD1) and the wall pattern (102) and between the second epitaxial pattern (SD2) and the wall pattern (102) comprises a second recess (101r2), and
a height of an uppermost portion of the second recess (101r2) is lower than a height of an uppermost portion of the wall pattern (102).

5. The semiconductor device of claim 4,
wherein the height of the uppermost portion of the second recess (101r2) is equal to or lower than a height of an uppermost portion of the first active pattern (AP1).

6. The semiconductor device of any preceding claim,
wherein the first epitaxial pattern (SD1) and the second epitaxial pattern (SD2) are separated by the wall structure (WS).

7. The semiconductor device of any preceding claim,
wherein the first epitaxial pattern (SD1) comprises an outer side surface (SD1s1) that extends in a direction that intersects the second direction and is spaced apart from the wall structure (WS), and
a distance (S2) between the outer side surface (SD1s1) and the first active pattern (AP1) in the second direction is equal to or less than a thickness (T1) of the liner film (101) in the second direction.

8. The semiconductor device of any preceding claim, comprising:
a gate spacer (142) extending along the side surface of the gate structure (GS), between the gate structure (GS) and the first epitaxial pattern (SD1),
wherein a thickness (T1) of the liner film (101) interposed between the first epitaxial pattern (SD1) and the wall pattern (102) is equal to or greater than a thickness (T2a) of the gate spacer (142).

9. The semiconductor device of any preceding claim, comprising:
a spacer pattern (144) on the substrate (100),
wherein the first epitaxial pattern (SD1) is interposed between the wall structure (WS) and the spacer pattern (144) in the second direction, and
a thickness (T1) of the liner film (101) interposed between the first epitaxial pattern (SD1) and the wall pattern (102) is equal to or greater than a thickness (T2b) of the spacer pattern (144).

10. The semiconductor device of any preceding claim, comprising:
a back source/drain contact (301) which extends into the substrate (100) and is connected to a lower surface of the first epitaxial pattern (SD1).

11. A semiconductor device of claim 1, wherein:
the substrate (100) comprises a first region (I) and a second region (II);
the first active pattern (AP1) comprises a first bridge pattern (111a) on the first region, wherein the first bridge pattern (111a) is spaced apart from the substrate (100) and extends in the first direction;
the second active pattern (AP2) comprises a second bridge pattern (111b) on the second region (II), wherein the second bridge pattern (111b) is spaced apart from the substrate (100) and extends in the first direction;
the gate structure (GS) comprises a gate electrode (130), which extends in the second direction, wherein the first bridge pattern (111a) and the second bridge pattern (111b) extend into the gate electrode (130);
the semiconductor device further comprises a gate spacer (142) which extends along a side surface of the gate electrode (130), wherein the first bridge pattern (111a) and the second bridge pattern (111b) extend into the gate spacer (142);
the first epitaxial pattern (SD1) is on a side surface of the gate spacer (142), wherein the first epitaxial pattern (SD1) is connected to the first bridge pattern (111a) in the first direction;
the second epitaxial pattern (SD2) is on the side surface of the gate spacer (142), wherein the second epitaxial pattern (SD2) is connected to the second bridge pattern (111b) in the first direction;
the wall structure (WS) is between the first region (I) and the second region (II), wherein the wall structure (WS) separates the first bridge pattern (111a) from the second bridge pattern (111b), and separates the first epitaxial pattern (SD1) from the second epitaxial pattern (SD2); and
a thickness (T1) of the liner film (101) interposed between the first epitaxial pattern (SD1) and the wall pattern (102) is equal to or greater than a thickness (T2a) of the gate spacer (142).

12. The semiconductor device of claim 11,
wherein an upper surface of the substrate (100) comprises a (110) crystal plane.

13. The semiconductor device of claim 11 or claim 12,
wherein an upper surface of the liner film (101) interposed between the first epitaxial pattern (SD1) and the wall pattern (102) comprises a recess (101r2), and
a height of an uppermost portion of the recess (101r2) is lower than a height of an uppermost portion of the first bridge pattern (111a).

14. The semiconductor device of any of claims 11-13,
wherein the first epitaxial pattern (SD1) comprises an outer side surface (SD1s1) that extends in a direction that intersects the second direction and is spaced apart from the wall structure (WS), and
a distance (T2b) between the outer side surface (SD1s1) and the first bridge pattern (101a) in the second direction is equal to or less than the thickness (T1) of the liner film (101) in the second direction.

15. The semiconductor device of any of claims 11-14 wherein:
the substrate (101) comprises a first side and a second side opposite to the first side;
the wall structure (WS) extends in the first direction on the first side;
the first bridge pattern (114a) is on the first side surface (WSa), and an upper surface of the first bridge pattern (114a) comprises a (110) crystal plane;
the second bridge pattern (114b) is on the second side surface (WSb), and an upper surface of the second bridge pattern (114b) comprises a (110) crystal plane;
the semiconductor device further comprises a back wiring structure (320) on the second side and a back source/drain contact (301) which extends into the substrate (100), wherein the back source/drain contact (301) connects the first epitaxial pattern (SD1) and the back wiring structure (320);
a height of an uppermost portion of the liner film (101) interposed between the first epitaxial pattern (SD1) and the wall pattern (102) is lower than a height of an uppermost portion of the first bridge pattern (114a); and
a part of the gate electrode (130) is interposed between the first bridge pattern (114a) and the second bridge pattern (114b) in the second direction.
